# EUROPÄISCHE PATENTSCHRIFT

(11) **EP 2 108 183 B1**
(45) Veröffentlichungstag und Bekanntmachung des Hinweises auf die Patenterteilung: **01.05.2019**
(21) Anmeldenummer: 07866220.2
(22) Anmeldetag: 20.12.2007
(51) Int. Cl.: H01H 13/81, H01H 13/88, H05K 1/00

(54) **FLÄCHENVERKLEIDUNGSELEMENT, FLÄCHENVERKLEIDUNGSELEMENT-ANORDNUNG UND VERFAHREN ZUM HERSTELLEN EINES FLÄCHENVERKLEIDUNGSELEMENTES**
SURFACE COVERING ELEMENT, ASSEMBLY OF SURFACE COVERING ELEMENTS AND METHOD FOR PRODUCING A SURFACE COVERING ELEMENT
ÉLÉMENT DE REVÊTEMENT DE SURFACE, ENSEMBLE D'ÉLÉMENTS DE REVÊTEMENT DE SURFACE ET PROCÉDÉ DE PRODUCTION D'UN ÉLÉMENT DE REVÊTEMENT DE SURFACE

(30) Priorität: 08.01.2007 DE 102007001225
(43) Veröffentlichungstag der Anmeldung: 14.10.2009
(73) Patentinhaber: SensProtect GmbH, 85635 Höhenkirchen-Siegertsbrunn (DE)
(72) Erfinder: LAUTERBACH, Christl, 85635 Höhenkirchen-Siegertsbrunn (DE); STEINHAGE, Axel, 85614 Kirchseeon (DE)
(74) Vertreter: Viering, Jentschura & Partner mbB Patent- und Rechtsanwälte
(86) Internationale Anmeldenummer: PCT/DE2007/002322
(87) Internationale Veröffentlichungsnummer: WO 2008/083659

(56) Entgegenhaltungen:
- EP-A- 1 355 332
- DE-A1- 3 709 306

## Beschreibung

Die Erfindung betrifft ein Flächenverkleidungselement, eine Flächenverkleidungselement-Anordnung und ein Verfahren zum Herstellen eines Flächenverkleidungselementes.

Seit einigen Jahren gibt es Bestrebungen seitens Forschung und Entwicklung, Technologie so zu gestalten, dass die eigentlichen Geräte in der Umgebung des Menschen in den Hintergrund treten und nur deren Funktion für einen Benutzer sichtbar wird. Ausprägungen solcher mit dem Schlagwort "Umgebungsintelligenz" (Ambient Intelligence) bezeichneten Entwicklungen sind beispielsweise Stereoanlagen, die keine Bedienpanele mehr enthalten sondern auf Gestik oder Sprache des Benutzers reagieren. Im Extremfall muss der Benutzer eine Melodie nur noch vor sich hin summen, um diese abspielen zu lassen. Wenngleich es sich bei dem vorgenannten Beispiel vermutlich um eine eher visionäre Anwendung von "Umgebungsintelligenz" handelt, so lässt sich das zugrunde liegende Prinzip doch auch in eher konventionellen Szenarien sinnvoll anwenden.

Von "Vorwerk & Co. Teppichwerke GmbH & Co. KG" und "Infineon Technologies AG" wurde auf der Fachmesse "Orgatec 2004" ein Funktionsprototyp eines interaktiven Teppichbodens (sogenannter "denkender Teppich" bzw. "Thinking Carpet") mit eingestickten Sensorfeldern zur Personendetektion vorgestellt, siehe [1]. Bei dem Teppichboden sind die Sensoren mit Kupferlitze mäanderförmig gestickt. Ferner sind Mikroelektronikmodule unter Verwendung konventioneller Bauelemente auf einer Platine (Printed Circuit Board, PCB) in das Textil integriert. Die Module sind innerhalb des gewebten Textils untereinander durch leitfähige Fasern zum Datenaustausch verbunden. Sensorsignale werden über eine sich selbst organisierende baumförmige Netzwerkarchitektur zum Rand des Textils weiter geleitet und über eine serielle Schnittstelle (Interface) zu einem externen Personal Computer (PC) geführt. Datenpakete eines Sensorsignals werden somit durch eines oder mehrere Netzwerkelemente hindurch bis zum Anschluss weitergereicht.

Ein bisher ungelöstes Problem bei dem oben beschriebenen Teppich besteht in der mechanischen Verbindung der Versorgungsleitungen und Datenleitungen zum Anschluss und zwischen verschiedenen Bahnen in der Fläche. Ferner sollten Techniken gefunden werden, mit denen sogenannte "intelligente Textilien" (Smart Textiles) kostengünstig und in einem Rolle-zu-Rolle-Prozess gefertigt werden können, um eine großvolumige Herstellung dieser Textilien zu ermöglichen.

In [4] sind eine Textilgewebestruktur, eine Flächenverkleidungsstruktur und ein Verfahren zum Bestimmen eines Abstands von Mikroelektronikelementen der Textilgewebestruktur zu mindestens einer Referenzposition offenbart.

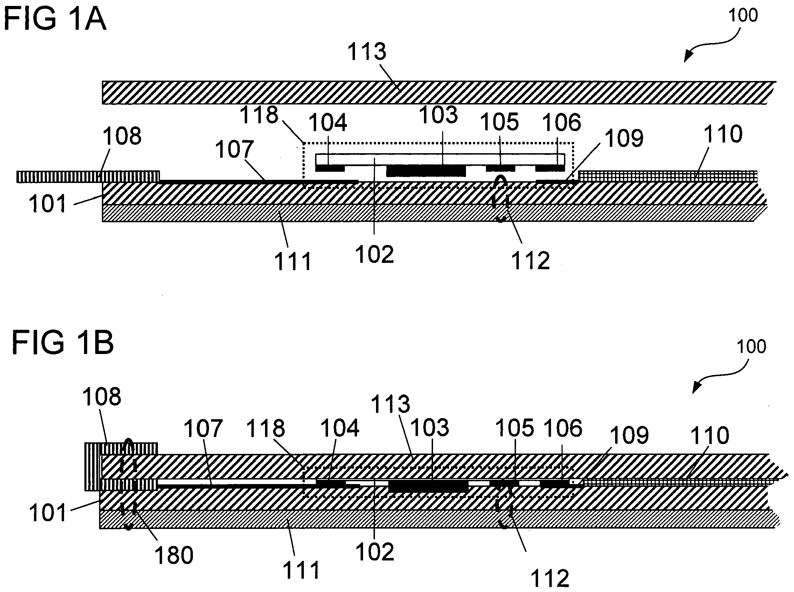

**Fig.1A** und **Fig.1B** zeigen Querschnittsansichten einer herkömmlichen Textilschicht-Anordnung 100, welche als textile Flächenverkleidungsstruktur für Sensor-/Aktor-Netzwerke verwendet werden kann. Mittels des Schichtaufbaus der Anordnung 100 kann eine "intelligente Unterlage" (Smart Underlay) mit einem integrierten Sensor-/Aktor-Netzwerk realisiert werden.

Unter einem Sensor-/Aktor-Netzwerk ist in diesem Zusammenhang ein Netzwerk zu verstehen, welches auf Netzwerkelementen basiert, welche jeweils mindestens ein elektronisches Bauelement aufweisen, und welche (beispielsweise in einem regelmäßigen Raster) in einer Flächenverkleidungsstruktur (beispielsweise einer textilen Flächenverkleidungsstruktur) integriert sind. Jedes Netzwerkelement des Sensor-/Aktor-Netzwerkes kann mindestens eines oder mehrere Sende-/Empfangselemente aufweisen. Ein Sende-/Empfangselement kann beispielsweise als Radiofrequenz-Element (RF-Element), beispielsweise als RFID-Tag, ausgebildet sein, und eine eindeutige Kennungs-Information (zum Beispiel eindeutige Identifikationsnummer) aufweisen, welche bei einer Installation des Systems einmalig in eine topografische Karte für einen Steuer-PC übernommen werden kann. Zusätzlich können in der Textilstruktur auch RFID-Tags für eine Robotersteuerung mit integriert werden. Jedes Netzwerkelement des Sensor-/Aktor-Netzwerkes kann mit einem oder mehreren Sensorelementen (Sensoren) und/oder Aktorelementen (Aktoren) elektrisch gekoppelt sein, wobei die Sensorelemente bzw. Aktorelemente ebenfalls in der Flächenverkleidungsstruktur integriert sind.

Die Netzwerkelemente (auch Netzwerkmodule genannt) sind mit einer Versorgungsspannung elektrisch gekoppelt, welche die für den Betrieb der Netzwerkelemente erforderliche elektrische Energie bereitstellt. Die Zuführung der Versorgungsspannung zu den einzelnen Netzwerkelementen erfolgt vorzugsweise entlang der Kanten des Textilaufbaus. Datenleitungen sind nicht vorgesehen, da die Datenübertragung beispielsweise drahtlos oder über das Stromnetz (Power line) erfolgt. Alternativ können die Netzwerkelemente untereinander über Leiterbahnen zum Datenaustausch verbunden und an der Versorgungsspannung angeschlossen sein.

Der in Fig.1A und Fig.1B gezeigte mehrlagige Textilaufbau 100 besteht aus einer Abfolge von leitfähigen und nichtleitfähigen Textillagen, die entsprechend der gewünschten elektrischen Eigenschaften durch textile Verbindungstechniken wie z.B. Sticken, Rascheln, Nähen, Wirken mit wahlweise leitfähigen oder nichtleitfähigen Filamenten oder auch durch Klebetechniken mit leitfähigen oder nichtleitfähigen bzw. anisotrop leitfähigen Klebern miteinander verbunden werden. Das Kontaktieren der Elektronikmodule erfolgt zum Beispiel mittels Klebens mit nichtleitfähigem oder anisotrop leitendem Kleber, wie es an sich in [2] beschrieben ist, oder mittels Lötens, Laserschweißens oder Verstickens mit leitfähigen Filamenten. Ziel ist, die für die Applikation gewünschte Elektronik mit Sensorflächen oder Aktorelementen so zu verbinden, dass zusätzlich zur elektrischen Verdrahtung ein mechanischer Schutz während des Gebrauchs gewährleistet wird. Gleichzeitig werden bei dem gezeigten Textilaufbau 100 Kurzschlüsse in der Struktur verhindert, eine Abschirmung gegen Störeinflüsse und ein einfacher und robuster elektrischer Anschluss für die Versorgungsspannung erreicht.

Fig.1A zeigt die Einzelschichten des Textilaufbaus 100 vor einem Laminierschritt, und Fig.1B zeigt den Textilaufbau 100 nach dem Laminieren. Die Textilschicht-Anordnung 100 weist eine erste nichtleitfähige Textilschicht 101 auf, sowie eine zweite nichtleitfähige Textilschicht 113, welche als Abdeckschicht nach oben dient. Die Textilschicht-Anordnung 100 weist ferner einen Mikroelektronik-Chip 103 auf, welcher zwischen der ersten Textilschicht 101 und der zweiten Textilschicht 113 ausgebildet ist. Der Chip 103 ist auf einer Hauptoberfläche eines Zwischenträgers (Interposer) 102 ausgebildet. Der Interposer 102 dient anschaulich als Träger für die in die Textilschicht-Anordnung 100 integrierte Elektronik. Die Textilschicht-Anordnung 100 weist ferner ein leitfähiges Textilband 108 auf, welches als Energieleitung zum Bereitstellen elektrischer Energie dient und mit einer äußeren Versorgungsspannungsquelle elektrisch koppelbar ist. Das Textilband 108 wird nach dem Laminieren um die linke Kante der zweiten Textilschicht 113 herum nach oben geklappt, so dass das Textilband 108 anschaulich einen linken Endabschnitt der zweiten Textilschicht 113 umschließt (siehe Fig.1B). Das Textilband 108 wird mittels Nähens mit nichtleitfähigem Garn 180 befestigt, so dass eine mechanische Verbindung mit Zugentlastung geschaffen wird.

Die Textilschicht-Anordnung 100 weist ferner eine auf einer oberen Oberfläche der ersten nichtleitfähigen Textilschicht 101 ausgebildete Zuleitung 107 auf, welche den Chip 103 mit der Energieleitung 108 und damit mit der Versorgungsspannung elektrisch koppelt. Auf der Hauptoberfläche des Zwischenträgers 102 sind ferner ein erster elektrischer Kontakt 104 für die Versorgungsspannung, ein zweiter elektrischer Kontakt 105 für Masse und ein dritter elektrischer Kontakt 106 für den Anschluss eines kapazitiven Sensors ausgebildet. Der Zwischenträger 102, der darauf ausgebildete Chip 103 und die Kontakte 104, 105, 106 bilden zusammen anschaulich ein Elektronikmodul 118, welches beispielsweise als Netzwerkelement eines Sensor-/Aktor-Netzwerkes dient.

Die Textilschicht-Anordnung 100 weist ferner eine elektrisch leitfähige Schicht 111 auf, wobei die erste nichtleitfähige Textilschicht 101 auf der elektrisch leitfähigen Schicht 111 ausgebildet ist. Die elektrisch leitfähige Schicht 111 bildet anschaulich eine Massefläche der Textilschicht-Anordnung 100 sowie eine Abschirmung zum Untergrund. Weiterhin weist die Textilschicht-Anordnung 100 eine elektrisch leitfähige Textilstruktur 110 auf, welche als eine Sensorfläche 110 für einen kapazitiven Sensor des Sensorbodens dient. Die Textilschicht-Anordnung 100 weist ferner eine auf der ersten nichtleitfähigen Textilschicht 101 ausgebildete elektrisch leitfähige Bahn 109 auf, welche als Anschlussleitung für die Sensorfläche 110 dient.

Die Textilschicht-Anordnung 100 weist ferner eine Durchkontaktierung 112 auf zum elektrischen Kontaktieren des Chips 103 (bzw. des zweiten elektrischen Kontakts 105) mit der elektrisch leitfähigen Schicht 111 (Masseleitung) durch die erste nichtleitfähige Textilschicht 101 hindurch.

EP 1 355 332 A2 beschreibt eine elektrische Kontaktierungseinrichtung mit elektrischen Kontaktstellen auf einem beweglichen, im Wesentlichen plattenförmigen Träger und mit diesen gegenüberliegenden Festkontakten, die nach einer Schaltbewegung des Trägers mit den Kontaktstellen kontaktieren, wobei die Kontaktstellen gegenseitig derart isoliert sind, dass sie zueinander und/oder zum Träger unterschiedliche Potenziale ermöglichen. Die elektrische Kontaktierungseinrichtung wird in einer Tastatur verwendet.

Der Erfindung liegt das Problem zugrunde, auf einfache und kostengünstige Weise einen Schichtaufbau für eine Flächenverkleidungsstruktur für integrierte Sensor-/Aktor-Netzwerke bereitzustellen.

Das Problem wird durch ein Flächenverkleidungselement, eine Flächenverkleidungselement-Anordnung sowie ein Verfahren zum Herstellen eines Flächenverkleidungselementes mit den Merkmalen gemäß den unabhängigen Patentansprüchen gelöst.

Beispielhafte Ausgestaltungen der Erfindung ergeben sich aus den abhängigen Patentansprüchen. Die weiteren Ausgestaltungen der Erfindung, die im Zusammenhang mit dem Flächenverkleidungselement beschrieben sind, gelten sinngemäß auch für die Flächenverkleidungselement-Anordnung sowie das Verfahren zum Herstellen eines Flächenverkleidungselementes.

Ein Flächenverkleidungselement weist eine elektrisch nichtleitfähige Schicht auf, sowie eine erste elektrisch leitfähige Schicht, welche zumindest über einem Teilbereich einer ersten Oberfläche der elektrisch nichtleitfähigen Schicht ausgebildet ist. Ferner weist das Flächenverkleidungselement eine zweite elektrisch leitfähige Schicht auf, welche zumindest über einem Teilbereich einer zweiten Oberfläche der elektrisch nichtleitfähigen Schicht ausgebildet ist, wobei die zweite Oberfläche der ersten Oberfläche gegenüberliegend ausgebildet ist. Ferner weist das Flächenverkleidungselement mindestens ein Durchgangsloch auf, welches in der elektrisch nichtleitfähigen Schicht und in der ersten elektrisch leitfähigen Schicht ausgebildet ist. Ferner weist das Flächenverkleidungselement mindestens einen integrierten Schaltkreis auf, welcher in dem mindestens einen Durchgangsloch angeordnet ist. Ferner weist das Flächenverkleidungselement mindestens ein erstes mechanisch flexibles Kontaktierungselement auf, welches den mindestens einen integrierten Schaltkreis mit der ersten elektrisch leitfähigen Schicht elektrisch kontaktiert. Ferner weist das Flächenverkleidungselement mindestens ein zweites Kontaktierungselement auf, welches den mindestens einen integrierten Schaltkreis mit der zweiten elektrisch leitfähigen Schicht elektrisch kontaktiert.

Bei einem Verfahren zum Herstellen eines Flächenverkleidungselementes wird eine erste elektrisch leitfähige Schicht über zumindest einem Teilbereich einer ersten Oberfläche einer elektrisch nichtleitfähigen Schicht gebildet. Ferner wird eine zweite elektrisch leitfähige Schicht über zumindest einem Teilbereich einer zweiten Oberfläche der elektrisch nichtleitfähigen Schicht gebildet, wobei die zweite Oberfläche der ersten Oberfläche gegenüberliegend ausgebildet ist. Ferner wird mindestens ein Durchgangsloch in der elektrisch nichtleitfähigen Schicht und in der ersten elektrisch leitfähigen Schicht gebildet. Ferner wird mindestens ein integrierter Schaltkreis in dem mindestens einen Durchgangsloch angeordnet. Ferner wird mindestens ein erstes mechanisch flexibles Kontaktierungselement zumindest teilweise in dem mindestens einen Durchgangsloch angeordnet, welches mindestens eine erste Kontaktierungselement den mindestens einen integrierten Schaltkreis mit der ersten elektrisch leitfähigen Schicht elektrisch kontaktiert. Ferner wird mindestens ein zweites Kontaktierungselement in dem mindestens einen Durchgangsloch angeordnet, welches mindestens eine zweite Kontaktierungselement den mindestens einen integrierten Schaltkreis mit der zweiten elektrisch leitfähigen Schicht elektrisch kontaktiert.

Ein Aspekt der Erfindung kann darin gesehen werden, dass ein vereinfachter Schichtaufbau für eine Flächenverkleidungsstruktur für integrierte Sensor- und Aktor-Netzwerke bereitgestellt wird.

Gemäß einer Ausgestaltung der Erfindung weist das Flächenverkleidungselement mindestens einen Zwischenträger auf, welcher zumindest teilweise in dem Durchgangsloch angeordnet ist. Der mindestens eine Zwischenträger kann eine erste Hauptoberfläche aufweisen, sowie eine zweite Hauptoberfläche, welche der ersten Hauptoberfläche gegenüberliegend ausgebildet ist. Bei der ersten Hauptoberfläche kann es sich beispielsweise um eine obere Oberfläche des Zwischenträgers handeln, bei der zweiten Hauptoberfläche um eine untere Oberfläche des Zwischenträgers, oder umgekehrt. Gemäß einer Ausgestaltung der Erfindung ist der mindestens eine integrierte Schaltkreis auf der ersten Hauptoberfläche (beispielsweise der oberen Oberfläche) des mindestens einen Zwischenträgers ausgebildet.

Gemäß einer anderen Ausgestaltung der Erfindung weist die zweite Hauptoberfläche (beispielsweise die untere Oberfläche) des mindestens einen Zwischenträgers eine gemeinsame Grenzfläche mit der ersten elektrisch leitfähigen Schicht und/oder mit der zweiten elektrisch leitfähigen Schicht auf.

Gemäß einer anderen Ausgestaltung der Erfindung weist das mindestens eine erste Kontaktierungselement mindestens einen ersten elektrischen Kontakt auf, welcher in einem Randbereich des Zwischenträgers ausgebildet ist. Der mindestens eine erste elektrische Kontakt (z.B. ein Kontaktpad) kann zum elektrischen Kontaktieren eines Sensorelementes (z.B. einer Sensorfläche eines kapazitiven Näherungssensors), und/oder eines Aktorelementes (z.B. einer Leuchtdiode (LED)) und/oder einer elektrischen Versorgungsleitung verwendet werden.

Gemäß einer anderen Ausgestaltung der Erfindung ist der mindestens eine Zwischenträger als mechanisch flexibler Zwischenträger ausgebildet, anders ausgedrückt als biegsamer Zwischenträger. Im Falle eines mechanisch flexiblen bzw. biegsamen Zwischenträgers kann der Randbereich des Zwischenträgers außerhalb des mindestens einen Durchgangsloches ausgebildet sein. Mit anderen Worten kann der Zwischenträger einen Durchmesser bzw. eine laterale Ausdehnung/Größe aufweisen, welcher/welche größer ist als der Durchmesser bzw. die Größe des Durchgangsloches, so dass anschaulich ein Teilbereich, i.e. der Rand, des Zwischenträgers "übersteht". Beim Anordnen des auf einem flexiblen Zwischenträger ausgebildeten integrierten Schaltkreises innerhalb des Durchgangsloches wird dann der Randbereich des Zwischenträgers anschaulich leicht verbogen und liegt auf der ersten elektrisch leitfähigen Schicht auf, während ein zentraler Bereich des Zwischenträgers auf der zweiten elektrischen leitfähigen Schicht aufliegt.

Ein mechanisch flexibler Zwischenträger kann ein geeignetes Flexmaterial aufweisen bzw. daraus bestehen. Gemäß einer Ausgestaltung der Erfindung weist der als mechanisch flexibler Zwischenträger ausgebildete Zwischenträger mindestens eines der folgenden Materialien auf: ein Polyimid-Material, Kapton, PET (Polyethylenterephthalat), PEN (Polyethylennaphthalat), ein Polysiloxan-Material. Alternativ oder zusätzlich können andere geeignete Materialien für den flexiblen Zwischenträger verwendet werden.

Gemäß einer anderen Ausgestaltung der Erfindung ist der mindestens eine erste elektrische Kontakt auf der zweiten Hauptoberfläche des mindestens einen Zwischenträgers ausgebildet und weist eine gemeinsame Grenzfläche mit der ersten elektrisch leitfähigen Schicht auf. Mit anderen Worten kann der mindestens eine erste elektrische Kontakt (z.B. ein Kontaktpad für den Anschluss eines Sensors und/oder einer Versorgungsleitung) auf der Unterseite des Zwischenträgers ausgebildet sein und eine gemeinsame Grenzfläche mit mindestens einem auf der Oberseite der nichtleitfähigen Basisschicht ausgebildeten elektrisch leitfähigen Bereich (z.B. der Sensorfläche bzw. der Versorgungsleitung) aufweisen und diesen somit elektrisch kontaktieren. Noch anders ausgedrückt ist der mindestens eine erste elektrische Kontakt mit der Oberseite mindestens eines elektrisch leitfähigen Bereiches der ersten elektrisch leitfähigen Schicht elektrisch leitend verbunden.

Gemäß einer anderen Ausgestaltung der Erfindung ist der mindestens eine Zwischenträger als mechanisch starrer Zwischenträger ausgebildet, mit anderen Worten als nichtflexibler Zwischenträger. Im Falle eines starren Zwischenträgers kann der Randbereich des Zwischenträgers innerhalb des mindestens einen Durchgangsloches ausgebildet sein. Mit anderen Worten können anschaulich bei einem mechanisch starren Zwischenträger in dem Randbereich des Zwischenträgers ausgebildete erste elektrische Kontakte (z.B. Kontaktpads) innerhalb des Durchgangsloches liegen.

Gemäß einer anderen Ausgestaltung der Erfindung weist ein als mechanisch starrer Zwischenträger ausgebildeter Zwischenträger mindestens eines der folgenden Materialien (auch als Substrat-Materialien bezeichnet) auf: ein glasfaserverstärktes Kunststoff-Material wie z.B. FR4 (= Epoxid-Kunstharz + Glasfasergewebe, FR = flame retardant (flammfest)), ein Keramik-Material wie z.B. Al₂O₃, ein Metallkernleiterplatten-Material (z.B. IMS = insulated metal substrate), ein High-Density Packaging (Chip-size Packages) Material, z.B. ein Laminat, Silizium, Glas, Keramik. Alternativ können andere geeignete Materialien bzw. Substrat-Materialien für den starren Zwischenträger verwendet werden.

Gemäß einer anderen Ausgestaltung der Erfindung ist bei Verwendung eines starren Zwischenträgers der mindestens eine erste elektrische Kontakt auf der ersten Hauptoberfläche des mindestens einen Zwischenträgers ausgebildet, und das mindestens eine erste Kontaktierungselement weist mindestens einen ersten leitfähigen flexiblen Kontaktstreifen auf, welcher mit einem ersten Ende auf dem mindestens einen ersten elektrischen Kontakt aufgebracht ist und mit einem zweiten Ende auf der ersten elektrisch leitfähigen Schicht aufgebracht ist. Alternativ kann der mindestens eine erste elektrische Kontakt auf der zweiten Hauptoberfläche des mindestens einen Zwischenträgers ausgebildet sein, wobei der mindestens eine erste leitfähige flexible Kontaktstreifen in diesem Fall mit seinem ersten Ende auf dem auf der zweiten Hauptoberfläche ausgebildeten ersten elektrischen Kontakt aufgebracht ist. In diesem Fall kann auf dem ersten Ende des mindestens einen ersten leitfähigen flexiblen Kontaktstreifens eine elektrisch isolierende Schicht aufgebracht sein, um einen Kurzschluss zu vermeiden.

Gemäß einer anderen Ausgestaltung der Erfindung ist das mindestens eine zweite Kontaktierungselement als eine Masseschicht des integrierten Schaltkreises ausgebildet, welche Masseschicht eine gemeinsame Grenzfläche mit der zweiten elektrisch leitfähigen Schicht aufweist. Mit anderen Worten kann der mindestens eine integrierte Schaltkreis so in dem Durchgangsloch des Flächenverkleidungselementes angeordnet sein, dass eine freiliegende Massefläche des integrierten Schaltkreises, welche beispielsweise auf der zweiten Hauptoberfläche (anschaulich der Unterseite) des Zwischenträgers ausgebildet ist, die zweite elektrisch leitfähige Schicht kontaktiert.

Gemäß einer anderen Ausgestaltung der Erfindung weist das mindestens eine zweite Kontaktierungselement mindestens einen zweiten elektrischen Kontakt auf, welcher in dem Randbereich des Zwischenträgers ausgebildet ist. Der mindestens eine zweite elektrische Kontakt kann auf der zweiten Hauptoberfläche des mindestens einen Zwischenträgers ausgebildet sein. Ferner kann das mindestens eine zweite Kontaktierungselement mindestens einen zweiten leitfähigen flexiblen Kontaktstreifen aufweisen, welcher mit einem ersten Ende auf dem mindestens einen zweiten elektrischen Kontakt aufgebracht ist und mit einem zweiten Ende auf der zweiten elektrisch leitfähigen Schicht aufgebracht ist. Mit anderen Worten kann ein auf der Unterseite des Zwischenträgers in dem Randbereich des Zwischenträgers ausgebildeter zweiter elektrischer Kontakt mittels eines zweiten leitfähigen flexiblen Kontaktstreifens mit der zweiten elektrisch leitfähigen Schicht elektrisch kontaktiert werden. Auf diese Weise kann beispielsweise eine Kontaktierung des integrierten Schaltkreises mit einer auf der Unterseite des Flächenverkleidungselementes ausgebildeten Massezuleitung erfolgen.

Gemäß einer anderen Ausgestaltung der Erfindung weist die textile, elektrisch nichtleitfähige Schicht mindestens eines der folgenden Materialien auf: ein Vlies-Material, ein Schaumstoff-Material, ein Kunststoff-Material, . Alternativ oder zusätzlich können andere geeignete Materialien für die elektrisch nichtleitfähige Schicht verwendet werden.

Gemäß einer anderen Ausgestaltung der Erfindung ist eine Klebeschicht zwischen der elektrisch nichtleitfähigen Schicht und der ersten elektrisch leitfähigen Schicht ausgebildet. Beispielsweise ist die erste elektrisch leitfähige Schicht unter Verwendung einer Klebeschicht auf die elektrisch nichtleitfähige Schicht auflaminiert.

Gemäß einer anderen Ausgestaltung der Erfindung ist die erste elektrisch leitfähige Schicht so strukturiert, dass sie eine Mehrzahl von elektrisch leitfähigen Bereichen aufweist, welche elektrisch leitfähigen Bereiche als elektrische Versorgungsleitung und/oder als Sensorfläche ausgebildet sind, wobei die elektrisch leitfähigen Bereiche mittels mindestens eines Trennbereiches voneinander elektrisch isoliert sind.

Gemäß einer anderen Ausgestaltung der Erfindung ist mindestens einer der Mehrzahl von elektrisch leitfähigen Bereichen als elektrische Versorgungsleitung ausgebildet und mit einem hohen elektrischen Potential (beispielsweise einem elektrischen Versorgungspotential) elektrisch koppelbar.

Anschaulich kann der mindestens eine integrierte Schaltkreis mittels der elektrischen Versorgungsleitung mit elektrischer Spannung bzw. Energie versorgt werden.

Gemäß einer anderen Ausgestaltung der Erfindung weist das Flächenverkleidungselement mindestens eine elektrisch leitfähige Bahn auf, welche zumindest über einem Teilbereich der zweiten Oberfläche der elektrisch nichtleitfähigen Schicht ausgebildet ist, wobei die mindestens eine elektrisch leitfähige Bahn in mindestens einem Randbereich des Flächenverkleidungselementes ausgebildet ist. Die mindestens eine elektrisch leitfähige Bahn kann als Masseleitung ausgebildet sein und mit einem niedrigen elektrischen Potential (beispielsweise dem elektrischen Massepotential) elektrisch koppelbar sein.

Gemäß einer anderen Ausgestaltung der Erfindung ist die zweite elektrisch leitfähige Schicht als elektrisch leitfähiger Klebestreifen ausgebildet, und das mindestens eine zweite Kontaktierungselement ist mittels des elektrisch leitfähigen Klebestreifens mit der mindestens einen in dem mindestens einen Randbereich des Flächenverkleidungselementes ausgebildeten elektrisch leitfähigen Bahn (beispielsweise der Masseleitung) elektrisch kontaktiert. Anschaulich kann der integrierte Schaltkreis mittels des elektrisch leitfähigen Klebestreifens mit der Masseleitung verbunden werden, zum Beispiel indem ein auf der Unterseite eines Zwischenträgers ausgebildeter zweiter elektrischer Kontakt (z.B. eine freiliegende Massefläche des Schaltkreises) mit dem elektrisch leitfähigen Klebestreifen verbunden wird.

Gemäß einer anderen Ausgestaltung der Erfindung weist das Flächenverkleidungselement eine elektrisch nichtleitfähige Klebeschicht auf zur mechanischen Befestigung des Zwischenträgers, welche elektrisch nichtleitfähige Klebeschicht zumindest teilweise auf der zweiten Hauptoberfläche des Zwischenträgers und/oder zumindest teilweise auf der zweiten elektrisch leitfähigen Schicht und/oder zumindest teilweise auf der elektrisch nichtleitfähigen Schicht ausgebildet ist.

Gemäß einer anderen Ausgestaltung der Erfindung ist die elektrisch nichtleitfähige Klebeschicht zwischen der zweiten elektrisch leitfähigen Schicht und dem Zwischenträger ausgebildet. In diesem Fall kann eine Aussparung in der elektrisch nichtleitfähigen Klebeschicht über dem zweiten elektrischen Kontakt (z.B. der freiliegenden Massefläche des integrierten Schaltkreises) ausgebildet sein, so dass eine elektrische Kontaktierung des zweiten elektrischen Kontakts mittels der zweiten elektrisch leitfähigen Schicht erfolgen kann.

Gemäß einer anderen Ausgestaltung der Erfindung weisen/weist der mindestens eine erste leitfähige Kontaktstreifen und/oder der mindestens eine zweite leitfähige Kontaktstreifen mindestens eines der folgenden Materialien auf: ein metallisiertes Flexmaterial, ein metallisiertes Gewebe, ein metallisiertes Vlies, eine Metallfolie, eine metallisierte Folie. Alternativ oder zusätzlich können andere geeignete elektrisch leitfähige Materialien für den mindestens einen ersten leitfähigen Kontaktstreifen und/oder den mindestens einen zweiten leitfähigen Kontaktstreifen verwendet werden.

Gemäß einer anderen Ausgestaltung der Erfindung sind/ist der mindestens eine erste leitfähige Kontaktstreifen und/oder der mindestens eine zweite leitfähige Kontaktstreifen unter Verwendung mindestens eines der folgenden Klebe-Materialien aufgebracht: ein metallgefüllter Epoxidkleber, ein anisotrop leitfähiger Kleber (ACA: anisotropic conductive adhesive), ein leitfähiger Kaltkleber, ein nichtleitfähiger Kleber.

Gemäß einer anderen Ausgestaltung der Erfindung ist der mindestens eine integrierte Schaltkreis als Elektronikmodul eingerichtet, beispielsweise als Netzwerkmodul oder Netzwerkelement eines Sensor-/Aktor-Netzwerkes.

Gemäß einer anderen Ausgestaltung der Erfindung ist eine Füllschicht auf dem mindestens einen integrierten Schaltkreis und/oder dem mindestens einen Zwischenträger in dem Durchgangsloch aufgebracht, welche Füllschicht das Durchgangsloch ausfüllt. Die Füllschicht dient anschaulich als Höhenausgleich sowie als mechanischer Schutz für die Elektronik des integrierten Schaltkreises.

Die Füllschicht kann eine Vergussmasse aufweisen. Gemäß einer Ausgestaltung der Erfindung weist die Füllschicht mindestens eines der folgenden Materialien auf: ein Epoxidharz-Material, ein Polyurethan-Material, ein Silikon-Material, ein Acrylat-Material. Alternativ oder zusätzlich kann die Füllschicht andere geeignete Materialien aufweisen. Alternativ kann das Durchgangsloch mit einem Vlies-Material (z.B. mit einem Stück Vlies) und/oder mit einem Schaumstoff-Material (z.B. mit einem Stück Schaumstoff), aufgefüllt werden. Mit anderen Worten können/kann eine Vliesabdeckung und/oder eine Schaumstoffabdeckung auf dem integrierten Schaltkreis in dem Durchgangsloch ausgebildet sein.

Gemäß einer anderen Ausgestaltung der Erfindung weist das Flächenverkleidungselement mindestens eine Datenverbindungsleitung auf, welche Datenverbindungsleitung über der ersten Oberfläche der elektrisch nichtleitfähigen Schicht und/oder über der zweiten Oberfläche der elektrisch nichtleitfähigen Schicht ausgebildet ist, und welche Datenverbindungsleitung mit dem Elektronikmodul elektrisch gekoppelt ist.

Mittels der mindestens einen Datenverbindungsleitung (im Folgenden auch als Datenleitung bezeichnet) kann eine drahtgebundene Kommunikation zwischen einem in dem Flächenverkleidungselement integrierten Elektronikmodul und mindestens einem anderen Elektronikmodul, welches beispielsweise in mindestens einem anderen zu dem Flächenverkleidungselement benachbart angeordneten Flächenverkleidungselement integriert ist, ermöglicht werden.

Die mindestens eine Datenleitung kann zum Beispiel von einem Randbereich des Flächenverkleidungselementes ausgehend zu dem Durchgangsloch hingeführt werden und dort mit einer Schnittstelle des Elektronikmoduls (zum Beispiel mittels eines Kontaktpads) elektrisch kontaktiert sein.

Gemäß einer anderen Ausgestaltung der Erfindung weist das Flächenverkleidungselement mindestens eine isolierende Schicht auf, welche auf der Oberseite und/oder auf der Unterseite des Flächenverkleidungselementes ausgebildet ist.
Die isolierende Schicht kann unter Verwendung einer Klebeschicht aufgebracht werden. Die isolierende Schicht kann beispielsweise als eine dünne Vliesschicht, als eine Schaumstoffschicht oder als Folie ausgebildet sein. Die beiden letzteren haben beispielsweise den Vorteil, dass sie gleichzeitig einen Feuchtigkeitsschutz für das Flächenverkleidungselement bieten.

Eine Flächenverkleidungselement-Anordnung weist eine Mehrzahl von nebeneinander angeordneten Flächenverkleidungselementen auf, wobei die Flächenverkleidungselemente mittels der elektrischen Versorgungsleitung und/oder mittels der Masseleitung miteinander elektrisch gekoppelt sind.

Gemäß einer Ausgestaltung der Erfindung weist die Flächenverkleidungselement-Anordnung eine Mehrzahl von nebeneinander angeordneten Bahnen auf, wobei die einzelnen Bahnen jeweils eine Rasterstruktur mit einer Mehrzahl von Flächenverkleidungselementen bzw. Rastern aufweisen können.

Gemäß einer anderen Ausgestaltung der Erfindung weisen die einzelnen Flächenverkleidungselemente bzw. Raster der Flächenverkleidungselement-Anordnung jeweils ein Elektronikmodul auf, welches mit einer oder mehreren in dem Flächenverkleidungselement integrierten Sensorflächen gekoppelt ist und zum drahtlosen Übermitteln der von einem Sensor empfangenen Sensorsignale eingerichtet ist. Mit anderen Worten kann das Elektronikmodul zur Drahtloskommunikation eingerichtet sein, indem es beispielsweise ein Sende-/Empfangselement zum drahtlosen Senden bzw. Empfangen von Signalen aufweist, beispielsweise ein RF-Element.

Eine Flächenverkleidungselement-Anordnung gemäß einer anderen Ausgestaltung der Erfindung weist eine Mehrzahl von Flächenverkleidungselementen mit Datenverbindungsleitungen für eine drahtgebundene Kommunikation auf. Die Verbindung der Datenleitungen der einzelnen Flächenverkleidungselemente kann beispielsweise dadurch erreicht werden, dass auf der Oberseite der Flächenverkleidungselement-Anordnung die Versorgungsspannung in Mäanderform um die einzelnen Flächenverkleidungselemente (Raster) der Flächenverkleidungselement-Anordnung geführt wird und die Versorgungsspannung zusätzlich durch jedes einzelne Elektronikmodul durchgeschaltet wird. Durch den Mäander zum Rand der Bahnen ergibt sich eine Öffnung zur Nachbarbahn, welche Öffnung für die kreuzungsfreie Durchführung einer Datenleitung genutzt werden kann.

Gemäß einer Ausgestaltung der Erfindung verlaufen die Datenverbindungsleitungen auf der Unterseite der Flächenverkleidungselement-Anordnung zwischen den einzelnen Elektronikmodulen parallel zum Rand einer Bahn. Die Module können an ihrer Unterseite entsprechende Kontaktpads zum Anschluss der Datenverbindungsleitungen aufweisen.

Bei einer Flächenverkleidungselement-Anordnung gemäß einer anderen Ausgestaltung der Erfindung laufen die Masseanschlüsse (elektrisch leitfähige Klebestreifen) der Module von einer Masseleitung am Rand einer Bahn im rechten Winkel zu den Modulen. Die Datenleitungen können parallel zu den Bahnen verlaufen. Die Kontaktierung der Datenleitungen kann an der Unterseite an den Schnittkanten der Bahnen oder an der Oberseite an den Bahnkanten erfolgen. Zur Kontaktierung der Datenleitungen miteinander kann beispielsweise ein elektrisch leitfähiger Streifen verwendet werden.

Gemäß einer anderen Ausgestaltung der Erfindung erfolgt das Bilden der ersten elektrisch leitfähigen Schicht, indem eine elektrisch leitfähige Schicht ganzflächig auf die erste Oberfläche der elektrisch nichtleitfähigen Schicht aufgebracht wird und nachfolgend strukturiert wird.

Das Strukturieren der elektrisch leitfähigen Schicht kann unter Verwendung eines Abtragungsverfahrens erfolgen, zum Beispiel unter Verwendung eines abtragenden maskenlosen Verfahrens, anders ausgedrückt, eines maskenlosen Abtragungsverfahrens. Als Abtragungsverfahren (auch Abtragverfahren genannt) kann beispielsweise mindestens eines der folgenden Verfahren verwendet werden: Lasertrennen, Stanzen, Sägen, Fräsen, Wasserstrahlschneiden, Ausbrennen. Alternativ oder zusätzlich kann ein anderes geeignetes Abtragungsverfahren verwendet werden.

Gemäß einer anderen Ausgestaltung der Erfindung werden die elektrisch leitfähigen Strukturen (elektrisch leitfähige Bereiche) direkt aufgebracht, zum Beispiel mittels eines belichtungsmaskenlosen Aufbringungsverfahrens, beispielsweise mittels eines Druckverfahrens, zum Beispiel mittels eines Siebdruckverfahrens.

Gemäß einer anderen Ausgestaltung der Erfindung erfolgt das Bilden der ersten elektrisch leitfähigen Schicht und/oder der zweiten elektrisch leitfähigen Schicht, indem mindestens eine Schicht, welche strukturierte leitfähige Bereiche auf einem nichtleitfähigen Material aufweist, auf die erste Oberfläche und/oder auf die zweite Oberfläche der elektrisch nichtleitfähigen Schicht aufgebracht wird. Die mindestens eine Schicht kann mindestens eines der folgenden Materialien aufweisen: ein Polyestergewebe mit eingewobenen leitfähigen Fäden (z.B. mit einem in Jacquardtechnik eingewobenen Muster aus leitfähigen Fäden), eine Kunststofffolie mit leitfähigen Bereichen, ein Vlies mit leitfähigen Bereichen, ein Papier mit leitfähigen Bereichen. Die leitfähigen Bereiche können beispielsweise mittels Bedruckens, mittels Bedampfens, mittels Besputterns oder galvanisch aufgebracht werden. Alternativ können gedruckte leitfähige Schichten stromlos verstärkt werden (z.B. unter Verwendung eines Verfahrens, wie es bei der Herstellung von RFID-Tag-Folien verwendet wird). Alternativ oder zusätzlich kann die Schicht andere geeignete Materialien aufweisen.

Gemäß einer anderen Ausgestaltung der Erfindung erfolgt das Bilden des Durchgangsloches unter Verwendung eines Abtragungsverfahrens. Als Abtragungsverfahren kann beispielsweise mindestens eines der folgenden Verfahren verwendet werden: Lasern, Stanzen, Sägen, Fräsen, Ausbrennen, Bohren, Wasserstrahlschneiden. Alternativ oder zusätzlich kann ein anderes geeignetes Abtragungsverfahren verwendet werden.

Gemäß einer anderen Ausgestaltung der Erfindung ist bei einem Verfahren zum Herstellen einer Flächenverkleidung der mindestens eine integrierte Schaltkreis auf einer ersten Hauptoberfläche mindestens eines mechanisch flexiblen Zwischenträgers ausgebildet. Ferner weist gemäß dieser Ausgestaltung das erste Kontaktierungselement mindestens einen ersten elektrischen Kontakt auf, welcher auf einer zweiten Hauptoberfläche des mindestens einen Zwischenträgers in einem Randbereich des mindestens einen Zwischenträgers ausgebildet ist, wobei die zweite Hauptoberfläche der ersten Hauptoberfläche gegenüberliegend ausgebildet ist. Ferner weist gemäß dieser Ausgestaltung das zweite Kontaktierungselement mindestens einen zweiten elektrischen Kontakt auf, welcher auf der zweiten Hauptoberfläche des mindestens einen Zwischenträgers ausgebildet ist. Ferner wird gemäß dieser Ausgestaltung der mindestens eine Zwischenträger zumindest teilweise in dem mindestens einen Durchgangsloch angeordnet, derart, dass der Randbereich des mindestens einen Zwischenträgers außerhalb des Durchgangsloches angeordnet ist, dass der mindestens eine erste elektrische Kontakt eine gemeinsame Grenzfläche mit der ersten elektrisch leitfähigen Schicht aufweist, und dass der mindestens eine zweite elektrische Kontakt eine gemeinsame Grenzfläche mit der zweiten elektrisch leitfähigen Schicht aufweist.

Gemäß einer anderen Ausgestaltung der Erfindung ist bei einem Verfahren zum Herstellen eines Flächenverkleidungselementes der mindestens eine integrierte Schaltkreis auf einer ersten Hauptoberfläche mindestens eines mechanisch starren Zwischenträgers ausgebildet. Ferner weist gemäß dieser Ausgestaltung das mindestens eine erste Kontaktierungselement mindestens einen ersten elektrischen Kontakt auf, welcher auf der ersten Hauptoberfläche des mindestens einen Zwischenträgers in einem Randbereich des mindestens einen Zwischenträgers ausgebildet ist. Ferner weist gemäß dieser Ausgestaltung das mindestens eine zweite Kontaktierungselement mindestens einen zweiten elektrischen Kontakt auf, welcher auf einer zweiten Hauptoberfläche des mindestens einen Zwischenträgers ausgebildet ist, wobei die zweite Hauptoberfläche der ersten Hauptoberfläche gegenüberliegend ausgebildet ist. Ferner wird gemäß dieser Ausgestaltung der mindestens eine Zwischenträger in dem mindestens einen Durchgangsloch angeordnet, derart, dass der mindestens eine zweite elektrische Kontakt eine gemeinsame Grenzfläche mit der zweiten elektrisch leitfähigen Schicht aufweist. Ferner weist gemäß dieser Ausgestaltung das mindestens eine erste Kontaktierungselement mindestens einen ersten leitfähigen flexiblen Kontaktstreifen auf, welcher mit einem ersten Ende auf dem mindestens einen ersten elektrischen Kontakt aufgebracht wird und mit einem zweiten Ende auf der ersten elektrisch leitfähigen Schicht aufgebracht wird.

Gemäß einer anderen Ausgestaltung der Erfindung ist bei einem Verfahren zum Herstellen eines Flächenverkleidungselementes der mindestens eine integrierte Schaltkreis auf einer ersten Hauptoberfläche mindestens eines mechanisch starren Zwischenträgers ausgebildet. Ferner weist gemäß dieser Ausgestaltung das mindestens eine erste Kontaktierungselement mindestens einen ersten elektrischen Kontakt auf, welcher auf der ersten Hauptoberfläche des mindestens einen Zwischenträgers in einem Randbereich des mindestens einen Zwischenträgers ausgebildet ist. Ferner weist gemäß dieser Ausgestaltung das mindestens eine zweite Kontaktierungselement mindestens einen zweiten elektrischen Kontakt auf, welcher auf einer zweiten Hauptoberfläche des mindestens einen Zwischenträgers in dem Randbereich des mindestens einen Zwischenträgers ausgebildet ist, wobei die zweite Hauptoberfläche der ersten Hauptoberfläche gegenüberliegend ausgebildet ist. Ferner wird gemäß dieser Ausgestaltung der mindestens eine Zwischenträger in dem mindestens einen Durchgangsloch angeordnet. Ferner weist gemäß dieser Ausgestaltung das mindestens eine erste Kontaktierungselement mindestens einen ersten leitfähigen flexiblen Kontaktstreifen auf, welcher mit einem ersten Ende auf dem mindestens einen ersten elektrischen Kontakt aufgebracht wird und mit einem zweiten Ende auf der ersten elektrisch leitfähigen Schicht aufgebracht wird. Ferner weist gemäß dieser Ausgestaltung das mindestens eine zweite Kontaktierungselement mindestens einen zweiten leitfähigen flexiblen Kontaktstreifen auf, welcher mit einem ersten Ende auf dem mindestens einen zweiten elektrischen Kontakt aufgebracht wird und mit einem zweiten Ende auf der zweiten elektrisch leitfähigen Schicht aufgebracht wird.

Gemäß einer anderen Ausgestaltung der Erfindung werden/wird der mindestens eine erste leitfähige Kontaktstreifen und/oder der mindestens eine zweite leitfähige Kontaktstreifen unter Verwendung eines Klebeverfahrens und/oder eines Bondverfahrens aufgebracht. Mit anderen Worten kann der mindestens eine erste leitfähige Kontaktstreifen mittels eines Klebeschritts und/oder eines Bondschritts auf der ersten elektrisch leitfähigen Schicht kontaktiert werden, und/oder der mindestens eine zweite leitfähige Kontaktstreifen kann mittels eines Klebeschritts und/oder eines Bondschritts auf der zweiten elektrisch leitfähigen Schicht kontaktiert werden. Als Kleber können leitfähige Kleber wie zum Beispiel metallgefüllte Epoxidkleber, anisotrop leitfähige Kleber (ACA: anisotropic conductive adhesive) oder leitfähige Kaltkleber verwendet werden. Alternativ können auch nichtleitfähige Kleber, zum Beispiel in Verbindung mit Thermokompressionsbondverfahren (zum Beispiel nichtleitfähige thermoplastische Kleber), verwendet werden. Die Kontaktierung des ersten leitfähigen Kontaktstreifens und/oder des zweiten leitfähigen Kontaktstreifens auf dem starren Zwischenträger kann unter Verwendung der oben genannten Klebeschritte und/oder Bondschritte erfolgen, alternativ kann die Kontaktierung in der gleichen Weise erfolgen wie die Kontaktierung eines flexiblen Zwischenträgers auf der ersten elektrisch leitfähigen Schicht. Alternativ können für die Kontaktierung des ersten leitfähigen Kontaktstreifens und/oder des zweiten leitfähigen Kontaktstreifens auf dem starren Zwischenträger alle anderen genannten Methoden verwendet werden.

Ein Aspekt der Erfindung kann darin gesehen werden, dass ein Flächenverkleidungselement für eine großflächige Flächenverkleidung (Smart Underlay) bereitgestellt wird, mit der zum Beispiel unter einem Fußboden ein Sensornetzwerk (z.B. SensFloor®) realisiert werden kann, welches durch integrierte Näherungssensoren orts- und zeitaufgelöste Signale generiert, wenn sich eine Person und/oder ein Fahrzeug über den Boden bewegen/bewegt. Unsichtbar unter beliebige Bodenbeläge installiert, vereinfacht und verbessert diese Technologie Funktionen die derzeit von vielen getrennten Systemen erfüllt werden müssen. Darüberhinaus werden aber auch völlig neue Anwendungen ermöglicht, die von der Erhöhung der persönlichen Sicherheit über innovative Komfortfunktionen bis zur Einsparung von Energie reichen.

Beispielhafte Anwendungsgebiete eines Sensornetzwerkes unter einem Fußboden sind in den Bereichen Pflege und Gesundheit (z.B. Sturzerkennung), Komfort und Sicherheit, Haus-Automation, Facilitymanagement und Transport-Logistik zu sehen. Hierbei können Sensoren verwendet werden, die die Anwesenheit von Personen auf dem Fußboden erkennen können. Als Basistechnologie für das Smart Underlay werden Sensoren und mikroelektronische Komponenten verwendet, die beispielsweise in Laminaten aus Textilien, Kunststoffschäume oder Kunststofffolien eingebettet sind.

Ein Vorteil eines Ausführungsbeispiels der Erfindung kann darin gesehen werden, dass unter Verwendung des Flächenverkleidungselementes bzw. des Herstellungsverfahrens eine Flächenverkleidung (Smart Underlay) mit integrierten Sensoren/Aktoren und/oder integrierter Mikroelektronik (z.B. einem integrierten Sensor-/Aktor-Netzwerlc) hergestellt werden kann, welche Flächenverkleidung eine hohe Robustheit (z.B. gegenüber mechanischer Belastung), eine Rolle-zu-Rolle-Fertigbarkeit sowie eine geringe Bauhöhe aufweist, und welche außerdem leicht verlegbar ist und einen zu herkömmlichen Systemen konkurrenzfähigen Preis aufweist.

Ein anderer Aspekt der Erfindung kann darin gesehen werden, dass großflächige Flächenverkleidungselemente mit integrierten Sensor- und Aktornetzwerken bereitgestellt werden, mit deren Hilfe es möglich ist, Applikationen von "intelligenten Umgebungen" zu realisieren.

Ein anderer Aspekt der Erfindung kann darin gesehen werden, dass eine Flächenverkleidungsstruktur mit integrierter Mikroelektronik bereitgestellt wird, die weitgehend mit Standardprozessen hergestellt werden kann, wie sie heute in der Textilindustrie und bei der Kunststoffverarbeitung benutzt werden.

Es wird von einer nichtleitfähigen Basisschicht ausgegangen, deren Dicke der Dicke der integrierten Elektronik angepasst sein kann. Die für die Elektronikverdrahtung bzw. für Sensorflächen und Anschlüsse notwendigen leitfähigen Bereiche können durch ganzflächiges Aufbringen einer elektrisch leitfähigen Schicht auf die Basisschicht und anschließendem Strukturieren dieser Schicht mit Hilfe eines maskenlosen Verfahrens erzeugt werden. Alternativ kann auch eine nichtleitende Schicht aufgebracht werden, die bereits strukturierte leitfähige Bereiche aufweist.

Zur Integration eines Elektronikmoduls wird in dieser Schicht ein durchgehendes Loch (Durchgangsloch) erzeugt. Anschließend wird die Unterseite der Basisschicht ebenfalls mit leitfähigen Bereichen ausgestattet und im Bereich der Anschlüsse auf der Unterseite des Moduls mit einer Schicht aus selbstklebendem leitfähigen Material zur elektrischen Kontaktierung der leitfähigen Bereiche an der Unterseite versehen. Zusätzlich kann zur mechanischen Befestigung des Moduls noch ein selbstklebender nichtleitfähiger Bereich aufgebracht werden.

Die Elektronik kann in Form eines oder mehrerer Module mit flexiblen Anschlüssen (flexiblen Kontaktierungselementen) in das vorgesehene Loch eingebracht werden, wobei die Module auf der Unterseite mit dem selbstklebenden leitfähigen Material elektrisch verbunden werden. Die Anschlussbereiche für die Kontakte auf der Oberfläche des Textils werden durch die Flexibilität des Moduls bzw. der flexiblen Anschlussbereiche, d.h. mittels der flexiblen ersten Kontaktierungselemente, des Moduls ebenfalls kontaktiert.

Ein Vorteil der Erfindung kann darin gesehen werden, dass in dem Flächenverkleidungselement bzw. der Flächenverkleidungsstruktur selbst keine Durchkontaktierungen oder Zwischenverbindungen zwischen verschiedenen elektrisch leitfähigen Bereichen notwendig sind. Mittels des flexiblen oder teilweise flexiblen Elektronikmoduls können alle notwendigen Bereiche (z.B. Versorgungsleitungen, Masseleitungen, Sensorflächen) an der Ober- und Unterseite des Flächenverkleidungselementes elektrisch kontaktiert und damit alle gewünschten Verschaltungen realisiert werden. Das Anbringen des Moduls in der Aussparung bzw. dem Durchgangsloch der dickenangepassten Basisschicht verhindert mechanische Belastungen der Elektronikbauelemente des Moduls durch darüber angebrachte Schichten, wie z.B. Fußbodenbeläge, wenn die Flächenverkleidungsstruktur als Sensorboden eingesetzt wird. Ferner können die flexiblen elektrischen Kontaktierungselemente eine Trittbelastung ganz oder zumindest teilweise ausgleichen.

Ausführungsbeispiele der Erfindung sind in den Figuren dargestellt und werden im Folgenden näher erläutert. In den Figuren sind gleiche oder ähnliche Elemente, soweit sinnvoll, mit gleichen oder identischen Bezugszeichen versehen. Die in den Figuren gezeigten Darstellungen sind schematisch und daher nicht maßstabsgetreu gezeichnet.

Es zeigen
- Figur 1A und Figur 1B: Querschnittsansichten einer herkömmlichen Textilschicht-Anordnung;
- Figur 2A bis Figur 2F: verschiedene Prozessschritte eines Verfahrens zum Herstellen eines Flächenverkleidungselementes gemäß einem Ausführungsbeispiel der Erfindung;
- Figur 3A und Figur 3B: zwei Ansichten eines Elektronikmoduls mit flexiblen Kontaktierungselementen gemäß einem Ausführungsbeispiel der Erfindung;
- Figur 4A und Figur 4B: zwei Ansichten eines Elektronikmoduls mit flexiblen Kontaktierungselementen gemäß einem anderen Ausführungsbeispiel der Erfindung;
- Figur 5: zwei miteinander verbundene Flächenverkleidungselemente einer Flächenverkleidungselement-Anordnung gemäß einem Ausführungsbeispiel der Erfindung;
- Figur 6A bis Figur 6C: verschiedene Ansichten eines Flächenverkleidungselementes gemäß einem Ausführungsbeispiel der Erfindung;
- Figur 6D: ein Flächenverkleidungselement gemäß einem anderen Ausführungsbeispiel der Erfindung;
- Figur 6E: ein Flächenverkleidungselement gemäß einem anderen Ausführungsbeispiel der Erfindung;
- Figur 7A bis Figur 7C: verschiedene Ansichten eines Flächenverkleidungselementes gemäß einem anderen Ausführungsbeispiel der Erfindung;
- Figur 8: eine Flächenverkleidungselement-Anordnung gemäß einem Ausführungsbeispiel der Erfindung;
- Figur 9A und Figur 9B: zwei verschiedene Ansichten einer Flächenverkleidungselement-Anordnung gemäß einem anderen Ausführungsbeispiel der Erfindung.

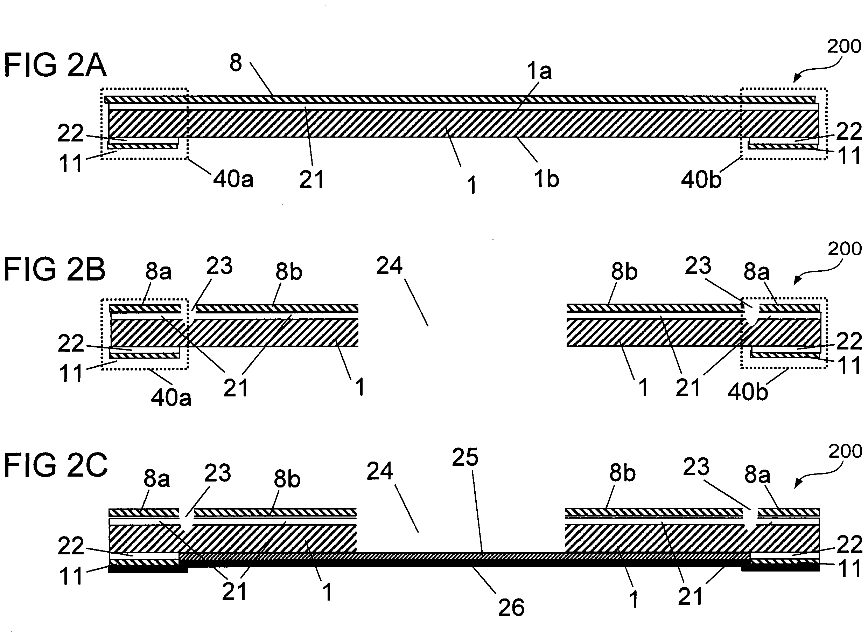

**Fig.2A** zeigt eine erste Querschnittsansicht eines Flächenverkleidungselementes 200 zur Veranschaulichung verschiedener Prozessschrittes eines Verfahrens zum Herstellen eines Flächenverkleidungselementes gemäß einem Ausführungsbeispiel der Erfindung.

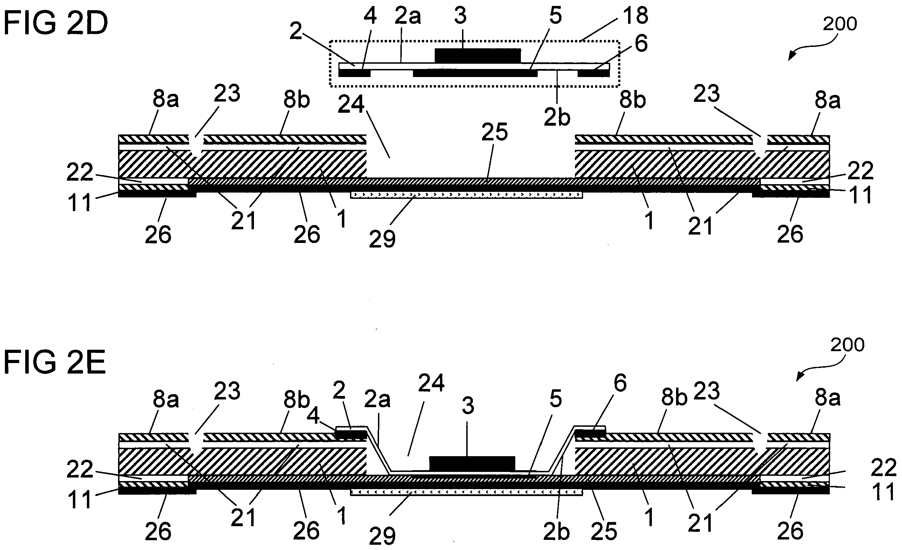

Das Flächenverkleidungselement 200 weist eine elektrisch nichtleitfähige Schicht 1 auf, welche als Basisschicht des Flächenverkleidungselementes 200 dient. Die Basisschicht 1 kann eine Dicke aufweisen, welche an die Dicke eines in die Basisschicht 1 zu integrierendes Elektronikmodul 18 angepasst ist (vgl. Fig.2E). Die Basisschicht 1 kann aus einem Vlies-Material, aus einem Schaumstoff-Material, aus Gipskarton, aus einem Kunststoff-Material, aus einem Hartfaserplatten-Material, aus Holz, aus Glas, aus Plexiglas, oder aus einem anderen geeigneten Material bestehen bzw. eines oder mehrere der vorgenannten Materialien aufweisen.

In einem Prozessschritt des Verfahrens wird über der elektrisch nichtleitfähigen Schicht 1 eine erste elektrisch leitfähige Schicht 8 gebildet. Die erste elektrisch leitfähige Schicht 8 wird über einer ersten Oberfläche 1a der elektrisch nichtleitfähigen Schicht 1 gebildet, anschaulich auf der Oberseite 1a der Basisschicht 1. Das Aufbringen der ersten elektrisch leitfähigen Schicht 8 erfolgt durch ganzflächiges Auflaminieren auf die Basisschicht 1 mittels einer ersten Klebeschicht 21, welche erste Klebeschicht 21 zwischen der elektrisch nichtleitfähigen Basisschicht 1 und der ersten elektrisch leitfähigen Schicht 8 gebildet wird. In einer alternativen Ausgestaltung kann die erste Klebeschicht 21 entfallen, zum Beispiel für den Fall, dass die Basisschicht 1 aus einem Material besteht, welches durch Aufheizen oder Anlösen der Oberfläche selber klebende Eigenschaften entwickelt (z.B. einer thermoplastischen Kunststofffolie oder einem Schaumstoff-Material). Die erste elektrisch leitfähige Schicht 8 bildet anschaulich eine obere Verdrahtungsschicht des Flächenverkleidungselementes 200, wobei aus der Verdrahtungsschicht 8 in nachfolgenden Prozessschritten elektrische Leiterbahnen 8a und/oder Sensorflächen 8b (beispielsweise für ein Sensor-/Aktor-Netzwerk) gebildet werden (vgl. Fig.2B).

In einem anderen Prozessschritt werden über einem Teilbereich einer zweiten Oberfläche 1b der elektrisch nichtleitfähigen Schicht 1, welche der ersten Oberfläche 1a gegenüberliegend ausgebildet ist, anschaulich auf der Unterseite 1b der Basisschicht 1 in einem ersten Randbereich 40a und in einem zweiten Randbereich 40b des Flächenverkleidungselementes 200 elektrisch leitfähige Bahnen 11 gebildet. Anschaulich werden auf der Unterseite 1b des Basismaterials 1 seitlich elektrisch leitfähige Bahnen 11 für eine Massezuleitung mittels einer zweiten Klebeschicht 22 auflaminiert. Das Auflaminieren der Masseleitungen 11 auf die Unterseite 1b der nichtleitfähigen Basisschicht 1 kann gleichzeitig mit dem Auflaminieren der ersten elektrisch leitfähigen Schicht 8 auf die Oberseite 1a der nichtleitfähigen Basisschicht 1 erfolgen. In einer alternativen Ausgestaltung kann, wie oben im Zusammenhang mit dem Aufbringen der ersten elektrisch leitfähigen Schicht 8 beschrieben, die zweite Klebeschicht 22 beim Aufbringen der elektrisch leitfähigen Bahnen 11 entfallen, wenn die Basisschicht 1 aus einem Material besteht, das durch Aufheizen oder Anlösen der Oberfläche selber klebende Eigenschaften entwickelt (z.B. einer thermoplastischen Kunststofffolie oder einem Schaumstoff-Material). Die elektrisch leitfähigen Bahnen 11 können mit einem niedrigen elektrischen Potential, z.B. dem Masse-Potential, elektrisch gekoppelt werden.

**Fig.2B** zeigt eine zweite Querschnittsansicht des Flächenverkleidungselementes 200 zur Veranschaulichung anderer Prozessschritte des Verfahrens zum Herstellen eines Flächenverkleidungselementes gemäß dem Ausführungsbeispiel der Erfindung.

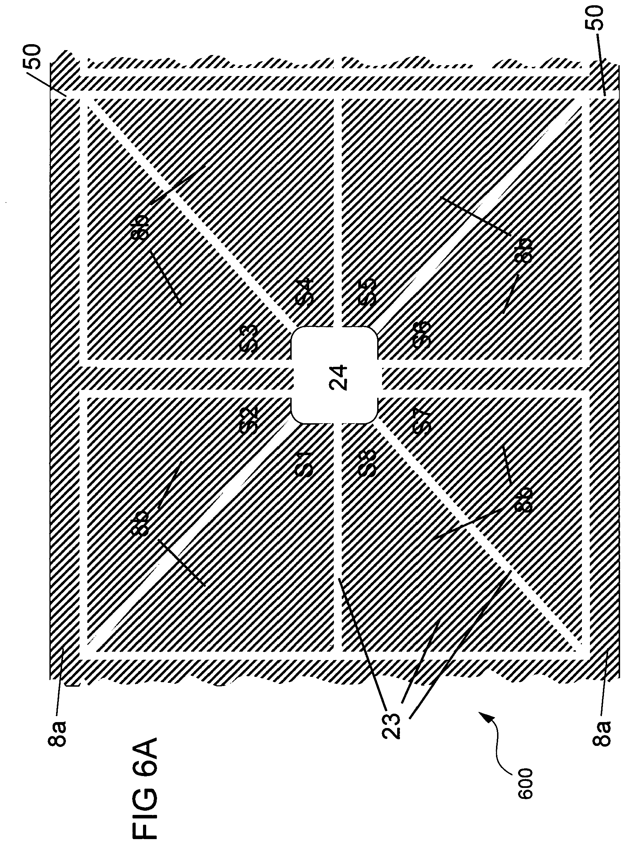

In einem anderen Prozessschritt wird die erste elektrische leitfähige Schicht 8 mittels eines Abtragungsverfahrens strukturiert, d.h. mittels Abtragens bzw. Entfernens von Material der elektrisch leitfähigen Schicht 8 und eventuell der ersten Klebeschicht 21 werden elektrisch isolierende Trennkanäle 23 in der ersten elektrisch leitfähigen Schicht 8 gebildet, so dass eine Mehrzahl von elektrisch leitfähigen Bereichen 8a, 8b gebildet werden, welche elektrisch leitfähigen Bereiche 8a, 8b mittels der Trennkanäle 23 gegenseitig voneinander elektrisch isoliert sind. Als Abtragverfahren kann beispielsweise ein maskenloses Abtragverfahren wie z.B. Lasertrennen, Stanzen, Sägen, Fräsen, Wasserstrahlschneiden oder Ausbrennen verwendet werden. Anschaulich werden durch ein abtragendes Verfahren in der oberen Verdrahtungsschicht 8 elektrisch isolierende Trennkanäle 23 gebildet, und durch die Trennkanäle werden eine oder mehrere Leiterbahnen 8a und/oder Sensorflächen 8b in der ersten elektrisch leitfähigen Schicht 8 definiert (vgl. auch Fig.6A). Die Leiterbahnen 8a können als elektrische Versorgungsleitungen zur Spannungsversorgung dienen und können mit einem hohen elektrischen Potential elektrisch gekoppelt werden. Die Versorgungsleitungen 8a können so definiert werden, dass die Spannungsversorgung 8a an die Bahnränder einer Flächenverkleidungsstruktur geführt wird.

In einem anderen Prozessschritt wird mindestens ein Durchgangsloch 24 in der elektrisch nichtleitfähigen Schicht 1 und der ersten elektrisch leitfähigen Schicht 8 gebildet. Anschaulich wird in einem Bereich bzw. in mehreren Bereichen, in dem/denen in einem nachfolgenden Prozessschritt die Elektronik eines Sensor-/Aktor-Netzwerkes integriert werden soll, ein durchgehendes Loch 24 durch die erste elektrisch leitfähige Schicht 8 und die nichtleitfähige Basisschicht 1 realisiert. Das Bilden des Durchgangsloches 24 kann beispielsweise mittels eines Abtragverfahrens wie z.B. Lasern, Stanzen, Sägen, Fräsen, Ausbrennen, Bohren, Wasserstrahlschneiden usw. erfolgen.

Alternativ zum Bilden der ersten elektrisch leitfähigen Schicht (genauer zum Bilden der strukturierten elektrisch leitfähigen Bereiche 8a, 8b der ersten elektrisch leitfähigen Schicht 8) mittels ganzflächigen Auflaminierens einer elektrisch leitfähigen Schicht auf die erste Oberfläche 1a der elektrisch nichtleitfähigen Basisschicht 1 und anschließenden Strukturierens der elektrisch leitfähigen Schicht kann die erste elektrisch leitfähige Schicht auch gebildet werden, indem auf die Oberseite 1a der Basisschicht 1 eine Schicht auflaminiert wird, welche bereits strukturierte leitfähige Bereiche auf nichtleitfähigem Material aufweist. Eine solche Schicht kann z.B. ein Polyestergewebe mit in Jaquardtechnik eingewobenem Muster aus leitfähigen Fäden sein oder eine nichtleitfähige Kunststofffolie, Vlies oder Papier mit leitfähigen Bereichen. Die leitfähigen Bereiche können beispielsweise mittels Bedruckens, mittels Bedampfens, mittels Besputterns oder galvanisch aufgebracht werden. Alternativ können gedruckte leitfähige Schichten stromlos verstärkt werden (z.B. mittels eines Verfahrens, wie es auch bei der Herstellung von RFID-Tag-Folien verwendet wird). In diesem Fall kann die Strukturierung der einzelnen Bereiche entfallen. Es ist dann lediglich nach dem Laminieren auf die Basis das Loch zum Einbringen des mindestens einen integrierten Schaltkreises (z.B. Elektronikmodul) zu erzeugen. Ebenso kann die Unterseite des Flächenverkleidungselementes 200 ebenfalls aus einer solchermaßen strukturierten Schicht bestehen. Das heißt, auf die zweite Oberfläche 1b (Unterseite 1b) der Basisschicht 1 kann ebenfalls eine Schicht, welche vorstrukturierte elektrisch leitfähige Bereiche auf einem nichtleitfähigen Material aufweist, aufgebracht werden (z.B. mittels Laminierens).

**Fig.2C** zeigt eine dritte Querschnittsansicht des Flächenverkleidungselementes 200 zur Veranschaulichung eines anderen Prozessschrittes des Verfahrens zum Herstellen eines Flächenverkleidungselementes gemäß dem Ausführungsbeispiel der Erfindung.

In dem gezeigten Prozessschritt wird eine zweite elektrisch leitfähige Schicht 26 über einem Teilbereich der zweiten Oberfläche 1b der elektrisch nichtleitfähigen Schicht 1 gebildet. Die zweite elektrisch leitfähige Schicht 26 ist als elektrisch leitfähiger Klebestreifen 26 mit leitfähigem Kleber 25 ausgebildet, wobei der Klebestreifen 26 so auf der Unterseite des Basismaterials 1 geführt bzw. aufgebracht ist, dass er die beiden außen (d.h. in den Randbereichen 40a, 40b des Flächenverkleidungselementes 200) verlaufenden Massezuleitungen 11 miteinander verbindet und gleichzeitig über das Loch 24 im Basismaterial 1 läuft und dort zur Kontaktierung eines Elektronikmoduls 18 verwendet werden kann (vgl. Fig.2E). Der Klebestreifen 26 kann in der Breite des Moduls 18 ausgeführt sein, und kann in diesem Fall gleichzeitig zur mechanischen Befestigung des Moduls 18 dienen. Alternativ kann die Massezuleitung 26, d.h. der Klebestreifen 26, aber auch lediglich die für eine Massekontaktierung des Moduls 18 notwendige Breite aufweisen. Für die mechanische Befestigung kann in diesem Fall eine elektrisch nichtleitfähige Schicht 29 mit nichtleitfähigem Kleber verwendet werden (vgl. Fig.2D).

**Fig.2D** zeigt eine vierte Querschnittsansicht des Flächenverkleidungselementes 200 zur Veranschaulichung anderer Prozessschritte des Verfahrens zum Herstellen eines Flächenverkleidungselementes gemäß dem Ausführungsbeispiel der Erfindung.

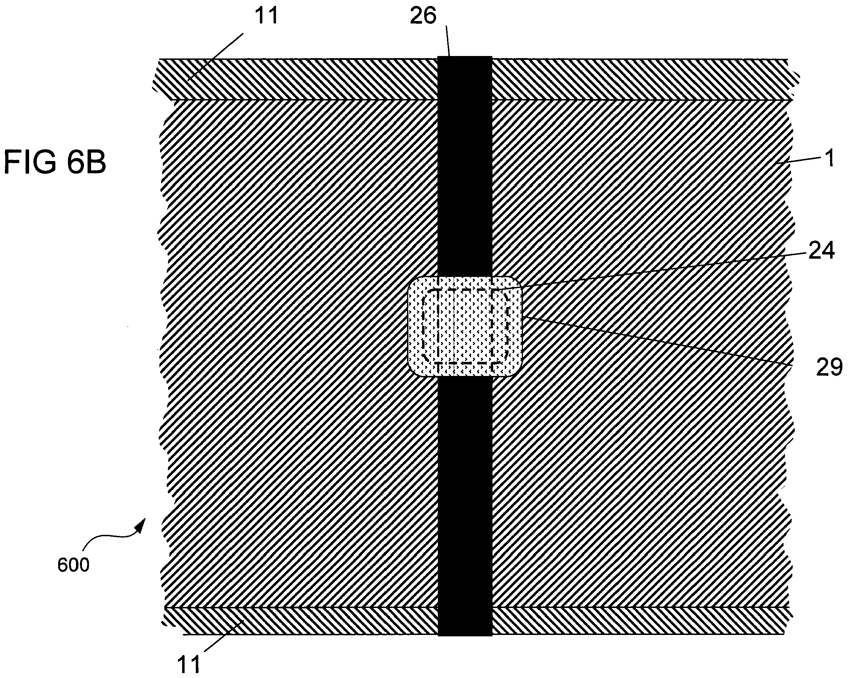

In einem anderen Prozessschritt des Verfahrens wird eine elektrisch nichtleitfähige Klebeschicht 29 von der Unterseite des Flächenverkleidungselementes 200 aus über dem Durchgangsloch 24 aufgebracht. Die Klebeschicht 29 ist anschaulich auf einem Teilbereich der zweiten elektrisch leitfähigen Schicht 26 und auf einem Teilbereich der Unterseite 1b der nichtleitfähigen Basisschicht 1 ausgebildet, derart, dass die Öffnung des Loches 24 überdeckt wird (vgl. Fig.6B).

In einem anderen Prozessschritt des Verfahrens wird ein Elektronikmodul 18 zumindest teilweise in dem Durchgangsloch 24 angeordnet. Das Modul 18 weist einen mechanisch flexiblen Zwischenträger 2 (Interposer) auf, wobei auf einer ersten Hauptoberfläche 2a des Zwischenträgers 2 mindestens ein integrierter Schaltkreis 3 (zum Beispiel ein Chip) ausgebildet ist und auf einer zweiten Hauptoberfläche 2b des Zwischenträgers 2, welche der ersten Hauptoberfläche 2a gegenüberliegend ausgebildet ist, eine Mehrzahl von ersten elektrischen Kontakten sowie ein zweiter elektrischer Kontakt 5 ausgebildet sind. Die Mehrzahl von ersten elektrischen Kontakten weist einen ersten ersten elektrischen Kontakt 4 auf (erstes Kontaktpad 4), welcher dazu dient, das Elektronikmodul 18 bzw. den integrierten Schaltkreis 3 mit der Versorgungsspannungsleitung 8a elektrisch zu kontaktieren sowie einen zweiten ersten elektrischen Kontakt 6 (zweites Kontaktpad 6), welcher dazu dient, das Elektronikmodul 18 bzw. den integrierten Schaltkreis 3 mit einer Sensorfläche 8b elektrisch zu kontaktieren. Alternativ oder zusätzlich können auch einer oder mehrere der Mehrzahl von ersten elektrischen Kontakten (Kontaktpads) vorgesehen sein zum elektrischen Kontaktieren mindestens eines Aktors (z.B. einer LED) mit dem Elektronikmodul 18. Der zweite elektrische Kontakt 5 ist anschaulich als freiliegende Massefläche des integrierten Schaltkreises 3 ausgebildet und dient dazu, den Schaltkreis 3 mit dem elektrisch leitfähigen Klebestreifen 26 und damit mit der Masseleitung 11 elektrisch zu kontaktieren. Der Zwischenträger 2 des Elektronikmoduls 18 kann aus einem Flexmaterial wie beispielsweise Polyimid, PET, Kapton, PEN, Polysiloxan usw. gebildet sein bzw. eines oder mehrere der vorgenannten Materialien aufweisen.

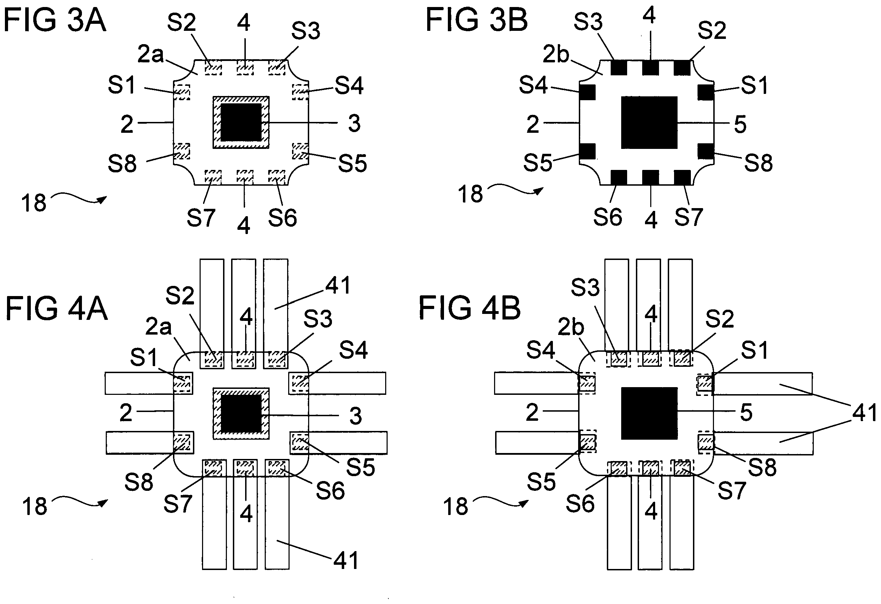

Gemäß einer alternativen Ausgestaltung des Verfahrens kann das Elektronikmodul einen mechanisch starren Zwischenträger aufweisen, welcher vollständig innerhalb des Durchgangsloches 24 angeordnet werden kann und mittels flexibler leitfähiger Kontaktstreifen mit der ersten elektrischen leitfähigen Schicht verbunden werden kann (vgl. Fig.4A und Fig.4B).

**Fig.2E** zeigt eine fünfte Querschnittsansicht des Flächenverkleidungselementes 200 zur Veranschaulichung eines anderen Prozessschrittes des Verfahrens zum Herstellen eines Flächenverkleidungselementes gemäß dem Ausführungsbeispiel der Erfindung.

In dem gezeigten Prozessschritt des Verfahrens wird das Elektronikmodul 18 bzw. der Zwischenträger 2 mit dem darauf ausgebildeten Chip 3, den ersten elektrischen Kontakten 4, 6 und dem zweiten elektrischen Kontakt 5 so in das Loch 24 eingebracht, dass die ersten elektrischen Kontakte (Kontalctpads) 4, 6 die leitfähige Beschichtung der Oberseite 1a der Basisschicht 1, d.h. die elektrisch leitfähigen Bereiche 8a, 8b, elektrisch kontaktieren, und dass der zweite elektrische Kontakt 5 (Masseschicht) das Modul 18 mit dem unteren Klebeband 26 elektrisch kontaktiert. Die mechanische Befestigung des Zwischenträgers 2 erfolgt mittels der Klebeschicht 29, indem der Zwischenträger 2 so angeordnet wird, dass die Klebeschicht 29 die zweite Hauptoberfläche 2b des Zwischenträgers 2 zumindest teilweise mechanisch kontaktiert. In einer alternativen Ausgestaltung kann die Klebeschicht 29 zur mechanischen Stabilisierung auch vor der zweiten elektrisch leitfähigen Schicht 26 aufgebracht sein. Das heißt, die Klebeschicht 29 ist in diesem Fall anschaulich zwischen der zweiten elektrisch leitfähigen Schicht 26 und dem Zwischenträger 2 des Elektronikmoduls 18 ausgebildet. In diesem Fall kann eine Aussparung in der Klebeschicht 29 über dem zweiten elektrischen Kontakt 5 ausgebildet werden, damit die zweite elektrisch leitfähige Schicht 26 den zweiten elektrischen Kontakt 5 des Zwischenträgers 2 elektrisch kontaktieren kann.

Aus Fig.2D und Fig.2E ist zu erkennen, dass der flexible Zwischenträger 2 einen größeren Durchmesser aufweist als das Durchgangsloch 24. Beim Einsetzen des Elektronikmoduls 18 in das Durchgangsloch 24 wird daher der Randbereich des mechanisch flexiblen Zwischenträgers 2 nach oben gebogen und die in dem Randbereich auf der Unterseite 2b des Zwischenträgers 2 ausgebildeten ersten elektrischen Kontakte (Kontaktpads) 4, 6 kontaktieren die außerhalb des Durchgangslochs 24 angeordneten elektrisch leitfähigen Bereiche 8a, 8b der ersten elektrisch leitfähigen Schicht 8, während der zweite elektrische Kontakt 5, d.h. die Masseschicht 5, auf einem zentralen Teilbereich der Unterseite 2b des Zwischenträgers 2 ausgebildet ist, welcher Teilbereich innerhalb des Durchgangsloches 24 liegt.

Der erste erste elektrische Kontakt 4 und der zweite erste elektrische Kontakt 6 bilden anschaulich zusammen mit dem Randbereich des flexiblen Zwischenträgers 2 jeweils ein erstes mechanisch flexibles Kontaktierungselement, welches den integrierten Schaltkreis 3 mit der ersten elektrisch leitfähigen Schicht 8 elektrisch kontaktiert. Der zweite elektrische Kontakt 5 wiederum bildet ein zweites Kontaktierungselement, welches den Schaltkreis 3 mit der zweiten elektrisch leitfähigen Schicht 26 elektrisch kontaktiert.

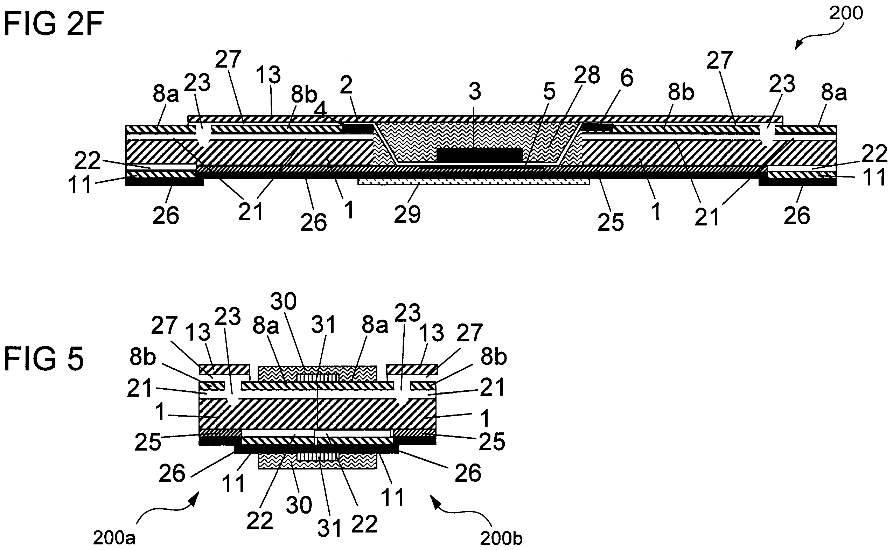

**Fig.2F** zeigt eine sechste Querschnittsansicht des Flächenverkleidungselementes 200 zur Veranschaulichung anderer Prozessschritte des Verfahrens zum Herstellen eines Flächenverkleidungselementes gemäß dem Ausführungsbeispiel der Erfindung.

In einem anderen Prozessschritt des Verfahrens wird zum Höhenausgleich und als mechanischer Schutz eine Füllschicht 28, zum Beispiel eine Vergussmasse, über dem Modul 18 aufgebracht. Als Füllmaterialien können beispielsweise Materialien wie Epoxidharz, Polyurethan, Silikon, Acrylat etc. verwendet werden. Die Füllschicht 28 kann so aufgebracht werden, dass sie das Durchgangsloch 24 ausfüllt, mit anderen Worten, dass sie eine im Wesentlichen koplanare Oberfläche mit der oberen Oberfläche der elektrisch leitfähigen Schicht 8 (bzw. der elektrisch leitfähigen Bereiche 8a, 8b) aufweist.

In einem anderen Prozessschritt des Verfahrens wird auf die Oberseite (in einer alternativen Ausgestaltung auch auf die Unterseite) des Textilaufbaus 200 eine isolierende Schicht 13 aufgebracht, beispielsweise eine dünne Vliesschicht, eine Schaumstoffschicht oder eine Folie. Die beiden letzteren bieten gleichzeitig einen Feuchtigkeitsschutz für die Flächenverkleidung. Die Isolierschicht 13 wird unter Verwendung einer dritten Klebeschicht 27 aufgebracht und kann so ausgebildet werden, dass die Randbereiche 40a, 40b des Flächenverkleidungselementes 200 mit den leitfähigen Streifen für die Versorgungsspannung 8a und Masse 11 zumindest teilweise von der Isolierschicht 13 freibleiben, so dass die einzelnen Flächenverkleidungselemente bzw. Bahnen einer Flächenverkleidungselement-Anordnung bzw. Flächenverkleidungsstruktur elektrisch leitend miteinander verbunden werden können (vgl. Fig.5).

**Fig.3A** und **Fig.3B** zeigen schematisch eine Ausgestaltung eines Elektronikmoduls 18 mit einem mechanisch flexiblen (d.h. biegsamen) Zwischenträger 2 zur Verwendung in einem Flächenverkleidungselement gemäß einem Ausführungsbeispiel der Erfindung. Fig.3A zeigt eine Ansicht der ersten Hauptoberfläche (Oberseite) 2a des Zwischenträgers 2, während Fig.3B eine Ansicht der zweiten Hauptoberfläche (Unterseite) 2b des Zwischenträgers 2 zeigt. Auf der ersten Hauptoberfläche 2a ist ein integrierter Schaltkreis 3 ausgebildet. Auf der zweiten Hauptoberfläche 2b sind zwei erste erste elektrische Kontakte 4 für den Anschluss der Versorgungsspannung sowie acht zweite erste elektrische Kontakte S1, S2, S3, S4, S5, S6, S7 und S8 zum elektrischen Anschluss von insgesamt acht Sensorflächen ausgebildet. Ferner ist auf der zweiten Hauptoberfläche 2b ein zweiter elektrischer Kontakt 5, welcher als Masseanschluss dient, ausgebildet. Es ist anzumerken, dass die auf der Unterseite 2b des Zwischenträgers 2 ausgebildeten Kontaktpads S1 bis S8 für die Sensoranschlüsse in Fig.3A umrisshaft angedeutet sind.

Der in Fig.3A und Fig.3B gezeigte flexible Zwischenträger 2 weist einen größeren Durchmesser auf als das Durchgangsloch 24, so dass beim Anordnen des Elektronikmoduls 18 in dem Durchgangsloch 24 die ersten elektrischen Kontakte 4 und S1 bis S8 außerhalb des Durchgangsloches 24 liegen und die Spannungszuleitungen 8a bzw. die Sensorflächen 8b elektrisch kontaktieren. Das heißt, die ersten ersten elektrischen Kontakte 4 weisen jeweils eine gemeinsame Grenzfläche mit jeweils einer Versorgungsleitung 8a auf, und die zweiten ersten elektrischen Kontakte S1 bis S8 weisen jeweils eine gemeinsame Grenzfläche mit jeweils einer Sensorfläche 8b auf. Der zweite elektrische Kontakt 5 (Masseschicht) wiederum weist eine gemeinsame Grenzfläche mit der zweiten elektrisch leitfähigen Schicht 26 auf.

Alternativ zu der oben beschriebenen Ausgestaltung des Zwischenträgers 2 als flexibler Zwischenträger kann das Elektronikmodul 18 auch einen Zwischenträger 2 aus einem mechanisch starren Material wie z.B. FR4 aufweisen. Eine solche Ausgestaltung eines Elektronikmoduls 18 ist in **Fig.4A** und **Fig.4B** gezeigt, wobei analog zu Fig.3A und Fig.3B die Oberseite 2a (Fig.4A) und die Unterseite (Fig.4B) des Zwischenträgers 2 gezeigt sind. Die Kontaktierung mit der ersten elektrisch leitfähigen Schicht 8 bzw. den elektrisch leitfähigen Bereichen 8a, 8b erfolgt hier mittels Anbringens von leitfähigen flexiblen Kontaktstreifen 41, wie z.B. metallisiertes Flexmaterial, metallisiertes Gewebe oder Vlies am Modul 18. Das heißt, die Kontaktstreifen 41 dienen als mechanisch flexibles Kontaktelement zum elektrischen Kontaktieren des integrierten Schaltkreises 3 mit der ersten elektrisch leitfähigen Schicht 8 des Flächenverkleidungselementes. Die Kontaktstreifen 41 werden dazu mit einem ersten Ende auf dem jeweiligen ersten elektrischen Kontakt des Elektronikmoduls 18 aufgebracht und mit einem zweiten Ende auf dem entsprechenden elektrisch leitfähigen Bereich 8a, 8b der ersten elektrisch leitfähigen Schicht 8.

Gemäß dem in Fig.4A und Fig.4B gezeigten Ausführungsbeispiel sind die ersten ersten elektrischen Kontakte 4 für den Anschluss der Versorgungsspannung und die zweiten ersten elektrischen Kontakte S1 bis S8 für den Anschluss der Sensorflächen auf der Oberseite 2a des Zwischenträgers 2 ausgebildet, während der zweite elektrische Kontakt 5 für den Masseanschluss auf der Unterseite 2b des Zwischenträgers 2 ausgebildet ist. Alternativ können auch die ersten elektrischen Kontakte 4 sowie S1 bis S8 auf der Unterseite 2b des Zwischenträgers 2 ausgebildet sein. In diesem Fall kann auf dem ersten Ende eines Kontaktstreifens, welches auf einem Kontaktpad ausgebildet ist, eine elektrisch isolierende Schicht aufgebracht sein, um einen Kurzschluss zu vermeiden.

In einer alternativen, nicht gezeigten, Ausführungsform kann auch der zweite elektrische Kontakt 5 mittels eines oder mehrerer flexibler leitfähiger Kontaktstreifen mit der zweiten elektrisch leitfähigen Schicht elektrisch kontaktiert werden.

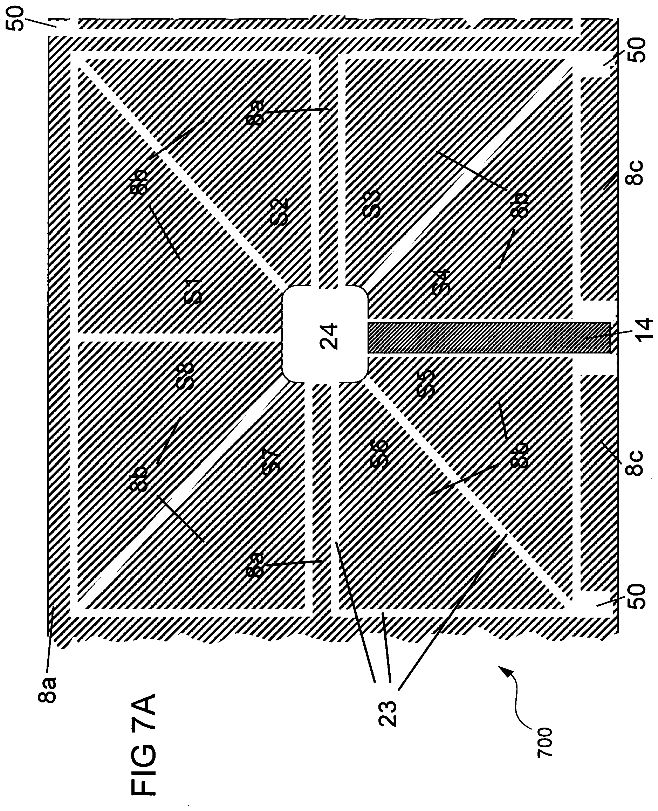

Es ist anzumerken, dass bei den in Fig.3A und 3B bzw. Fig.4A und 4B gezeigten Ausgestaltungen eines Elektronikmoduls 18 alternativ auch eine von acht verschiedene Anzahl an Sensorflächen an das Elektronikmodul 18 angeschlossen werden können und dementsprechend eine andere Anzahl an Kontaktpads dafür auf dem jeweiligen Zwischenträger 2 vorgesehen sein kann. Ferner können auch ein oder mehrere Kontaktpads für den Anschluss eines oder mehrerer Aktorelemente (z.B. LEDs) auf dem Zwischenträger 2 ausgebildet sein. Außerdem können Kontaktpads für den Anschluss von Datenverbindungsleitungen (vgl. Fig.7A bis Fig.7C) vorgesehen sein.

Nach der Montage eines auf einem starren Zwischenträger ausgebildeten Moduls 18 in dem Durchgangsloch 24 werden die leitfähigen flexiblen Kontaktstreifen 41 mittels eines Klebe- oder Bondschrittes auf der Oberfläche der ersten elektrisch leitfähigen Schicht 8 kontaktiert. Als Kleber können beispielsweise leitfähige Kleber, wie z.B. metallgefüllte Epoxidkleber, anisotrop leitfähige Kleber (ACA: anisotropic conductive adhesive) oder auch nichtleitfähige Kleber in Verbindung mit Thermokompressionsbondverfahren, sowie leitfähige Kaltkleber verwendet werden. Es ist anzumerken, dass im Falle eines mechanisch starren Zwischenträgers dieser einen solchen Durchmesser bzw. eine solche Größe aufweist, dass der Zwischenträger vollständig innerhalb des Durchgangsloches angeordnet werden kann. Das heißt, der Randbereich des Zwischenträgers ist in diesem Fall innerhalb des Durchgangsloches ausgebildet.

Ein Vorteil der Erfindung, beispielsweise gegenüber der in Fig.1A und Fig.1B gezeigten Textilschicht-Anordnung 100, kann darin gesehen werden, dass bei dem Flächenverkleidungselement 200 bzw. bei dessen Herstellung nur noch eine nichtleitfähige Basisschicht 1 notwendig ist.

Ein anderer Vorteil der Erfindung kann darin gesehen werden, dass bei dem oben beschriebenen Flächenverkleidungselement 200 das Elektronikmodul 18 alle notwendigen Verbindungen zwischen der ersten elektrisch leitfähigen Schicht 8 auf der Oberseite 1a des Basismaterials 1 und der zweiten elektrisch leitfähigen Schicht 26 auf der Unterseite 1b des Basismaterials 1 bereitstellt. Durchkontaktierungen durch das Basismaterial, wie sie die im Zusammenhang mit Fig.1A und Fig.1B beschriebene Textilschicht-Anordnung 100 aufweist (Bezugszeichen 112 in Fig.1A und Fig.1B), sind daher bei dem Flächenverkleidungselement 200 nicht erforderlich.

**Fig.5** zeigt das Verbinden zweier Flächenverkleidungselemente 200a, 200b bzw. Bahnen untereinander gemäß einem Ausführungsbeispiel der Erfindung. Die seitlichen Anschlüsse für die Versorgungsspannung 8a und Masse 11 eines ersten Flächenverkleidungselementes 200a und eines zweiten Flächenverkleidungselementes 200b werden aneinander gelegt und durch elektrisch leitfähige Klebebänder 30 miteinander elektrisch verbunden. In der Mitte der Klebebänder 30 kann noch bei mindestens einem der beiden Streifen ein zusätzlich aufgebrachter isolierender Streifen 31 sein. Dieser Streifen kann im Gebrauch des Flächenverkleidungsmoduls verhindern, dass durch ein eventuelles Auseinanderwandern der Bahnen und Zusammendrücken der Streifen 30 ein elektrischer Kurzschluss in der Flächenverkleidung entsteht.

In **Fig.6A** bis **Fig.6C** ist ein Flächenverkleidungselement 600 gemäß einem Ausführungsbeispiel der Erfindung dargestellt. Das Flächenverkleidungselement 600 ist Teil einer Flächenverkleidungselement-Anordnung bzw. Flächenverkleidungsstruktur, mit der ein sensitiver Fußboden aufgebaut werden kann. Die Flächenverkleidungsstruktur kann als Unterlage unter allen herkömmlichen Bodenbelägen verlegt werden. Sie besteht aus einzelnen Bahnen, die aneinander anstoßend verlegt werden können und eine Rasterstruktur aus nebeneinander ausgebildeten Flächenverkleidungselementen 600 (auch Rastern genannt) aufweisen. Jedes Flächenverkleidungselement bzw. Raster 600 besteht aus acht Sensorflächen 8b (S1 bis S8), Zuleitungen 8a für die Versorgungsspannung und einem Elektronikmodul 18. Alternativ kann das Flächenverkleidungselement 600 auch eine andere Anzahl an Sensorflächen aufweisen. Das Elektronikmodul 18 ist mit den Sensoren 8b und der Versorgungsleitung 8a auf der Oberfläche der Flächenverkleidungsstruktur verbunden, sowie auf der Modulunterseite mittels eines elektrisch leitfähigen Klebestreifens 26 mit der Masseleitung 11 auf der Unterseite der Flächenverkleidungsstruktur. Die Sensordaten können mittels eines in dem Elektronikmodul 18 ausgebildeten Sende-/Empfangselementes (z.B. RF-Element) direkt von dem Elektronikmodul 18 zu einem externen Empfänger gefunkt werden, so dass Datenleitungen in der Flächenverkleidungsstruktur bzw. in den einzelnen Flächenverkleidungselementen 600 nicht erforderlich sind.

In Fig.6A ist die Oberseite eines Rasters 600 der Flächenverkleidungsstruktur gezeigt. An beiden Außenbahnen laufen die Versorgungsleitungen 8a, welche jeweils zu einem Durchgangsloch 24 in der Mitte des Rasters 600 führen, welches Loch 24 für den Einbau des Elektronikmoduls 18 vorgesehen ist. Die Trennungslinien 23 bzw. Trennungskanäle 23 zwischen den elektrisch leitfähigen Strukturen (d.h. den Zuleitungen 8a und den Sensorflächen 8b) und das Loch 24 können in einem Arbeitsschritt in einer zuvor ganzflächig aufgebrachten elektrisch leitfähigen Schicht 8 ausgeführt werden (vgl. Fig.2A und Fig.2B). Die Trennschnitte 50 in der Versorgungsleitung 8a sind optional und können nach der Montage des Moduls 18 zum Anlegen der Versorgungsspannung an ein bestimmtes Raster für Testzwecke genutzt werden, ohne dass alle anderen Raster ebenfalls unter Spannung stehen. Die Trennschnitte 50 können dann bei der Installation des Bodens (vgl. Fig.5) durch ein leitfähiges Klebeband 30 überbrückt werden.

Fig.6B zeigt die Unterseite des Rasters 600 der Flächenverkleidungsstruktur mit der elektrisch nichtleitfähigen Basisschicht 1, der seitlichen Masseleitungen 11 am Rand der Bahn sowie der Masseverbindung des Moduls 18 mit elektrisch leitfähigem Klebeband 26. Die Aussparung 24 bzw. das Durchgangsloch 24 ist um die Ausdehnung der Kontaktpads 4, 6 kleiner als das Modul 18 (vgl. Fig.2D und Fig.2E). Das Modul 18 wird zusätzlich mit einem nichtleitfähigen Selbstklebeband 29 abgedeckt, um das Modul 18 zusätzlich mechanisch zu befestigen.

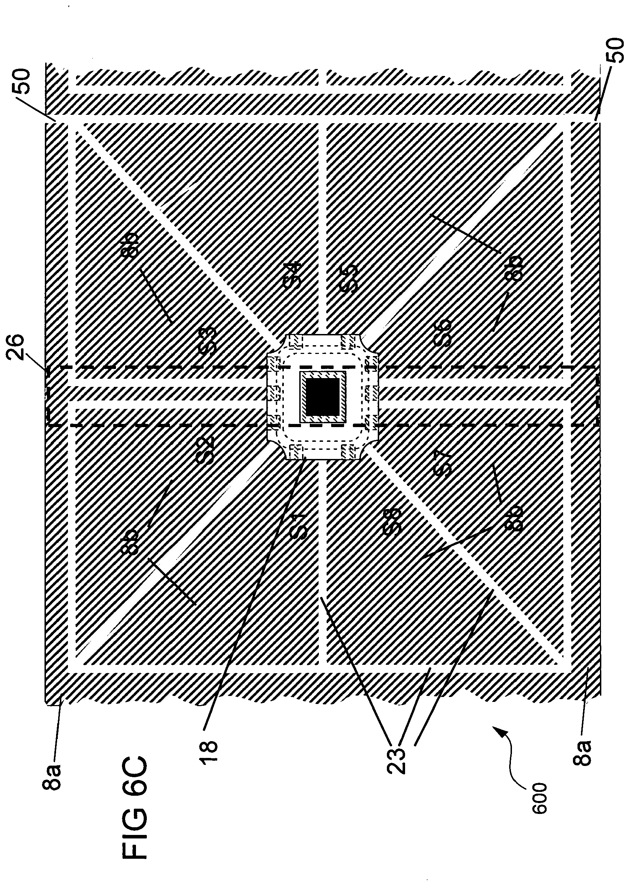

Fig.6C zeigt das Raster 600 der Flächenverkleidungsstruktur von der Oberseite nach der Bestückung mit einem flexiblen Modul 18, d.h. beispielsweise einem Modul 18 mit einem mechanisch flexiblen Zwischenträger 2 wie in Fig.3A und Fig.3B gezeigt. Die Kontaktpads an der Unterseite des flexiblen Moduls 18 kontaktieren die elektrisch leitfähigen Bereiche 8a (Zuleitungen für Versorgungsspannung) und 8b (Sensorflächen) auf der Oberseite der Flächenverkleidungsstruktur. In Fig.6C ist der auf der Unterseite des Flächenverkleidungselementes 600 ausgebildete elektrisch leitfähige Klebestreifen 26, welcher das Modul 18 mit den Masseleitungen 11 kontaktiert (vgl. Fig.6B), als Umrisslinie dargestellt.

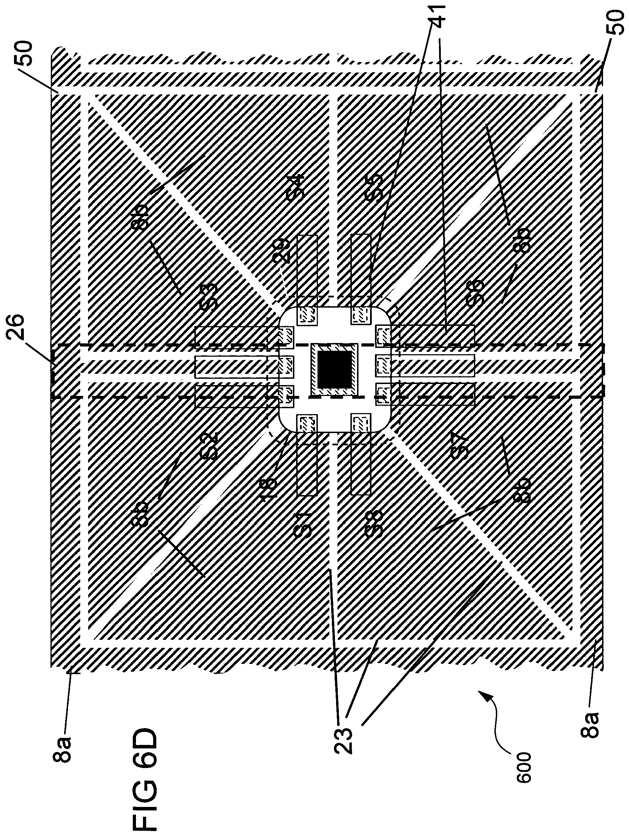

Gemäß einem alternativen, in **Fig.6D** gezeigten Ausführungsbeispiel kann in dem Durchgangsloch 24 des Flächenverkleidungselementes 600 der Flächenverkleidungsstruktur ein starres Modul 18 angeordnet sein, beispielsweise ein Modul 18 mit einem mechanisch starren Zwischenträger 2 sowie mit leitfähigen flexiblen Kontaktstreifen 41 als flexiblen Kontaktierungselementen, wie in Fig.4A und Fig.4B gezeigt. In diesem Fall weist die Aussparung 24 eine Größe auf, die ausreicht, um das komplette Modul 18 zu fassen. Die flexiblen Kontaktstreifen 41 sind mit einem ersten Ende auf einem Kontaktpad des Moduls 18 aufgebracht und mit einem zweiten Ende auf dem jeweiligen leitfähigen Bereich 8a, 8b. In Fig.6D ist auch die auf der Unterseite des Flächenverkleidungselementes 600 ausgebildete elektrisch nichtleitfähige Klebeschicht 29, welche zur mechanischen Befestigung des Moduls 18 dient, als Umrisslinie dargestellt.

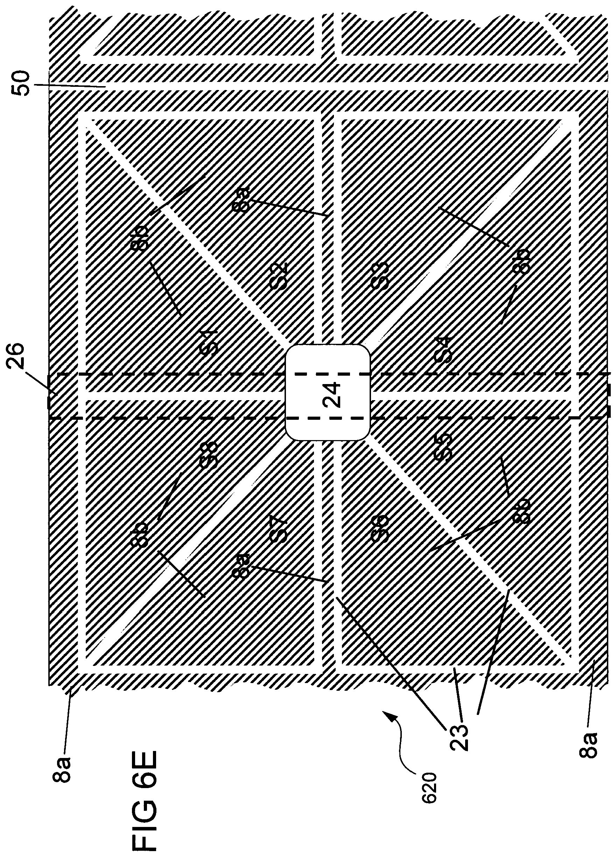

**Fig.6E** zeigt eine zu der in Fig.6A gezeigten Ausgestaltung alternative Ausgestaltung eines Flächenverkleidungselementes 620. Bei dem Flächenverkleidungselement 620 ist das Sensorfeld (Sensorflächen S1 bis S8) gegenüber der in Fig.6A gezeigten Anordnung um 90 Grad im Uhrzeigersinn gedreht. Die Zuleitungen 8a für die Versorgungsspannung laufen hier parallel zum Bahnrand. Zur getrennten Messung der Module 18 wird der Trennschnitt 50 auf ganzer Bahnbreite ausgeführt. Ein Vorteil dieser Anordnung kann darin gesehen werden, dass die Zuleitungen 8a für die Versorgungsspannung an der Oberseite der Flächenverkleidung und die Zuleitung 26 für die Masse an der Unterseite sich nicht direkt gegenüber liegen, wodurch die Kurzschlusswahrscheinlichkeit durch versehentliches Einbringen von elektrisch leitfähigen Teilen wie zum Beispiel Nägeln, Schrauben, Büroklammern etc. während des Gebrauchs verringert wird.

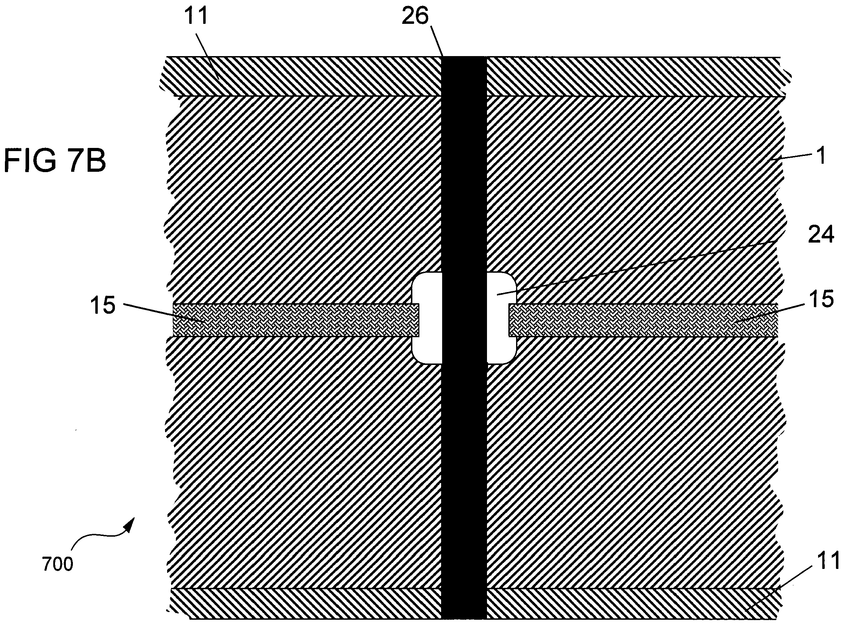

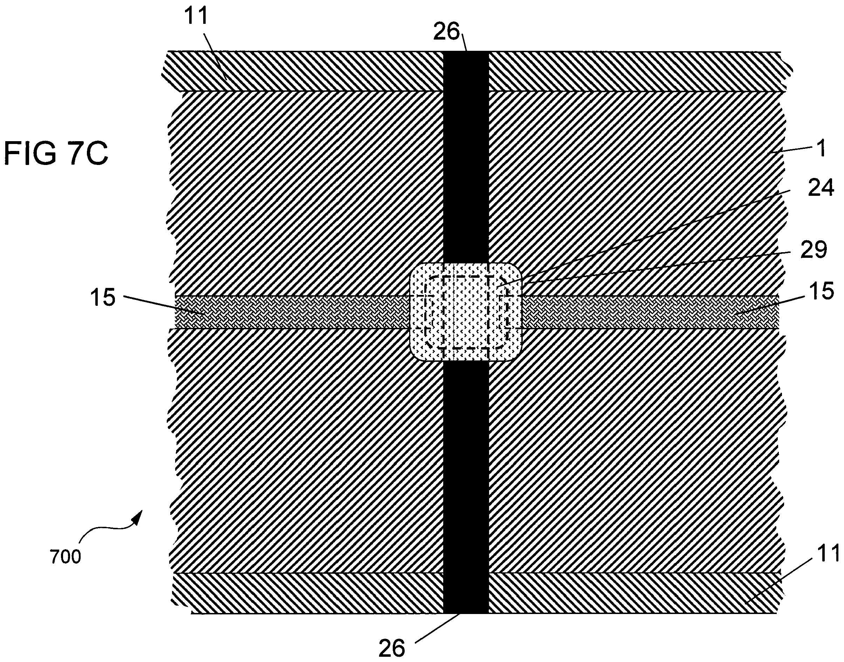

**Fig.7A** bis **Fig.7C** zeigen ein Flächenverkleidungselement 700 mit kapazitiven Sensoren S1 bis S8 gemäß einem anderen Ausführungsbeispiel der Erfindung, wobei Fig.7A eine Ansicht der Oberseite des Flächenverkleidungselementes 700 zeigt und Fig.7B und Fig.7C zwei verschiedene Ansichten der Unterseite des Flächenverkleidungselementes 700 zeigen. Der Hauptunterschied zu den vorhergehend beschriebenen Ausführungsbeispielen besteht darin, dass mittels des Flächenverkleidungselementes 700 bzw. einer Flächenverkleidungselement-Anordnung, welche eine Mehrzahl von Flächenverkleidungselementen 700 aufweist, eine drahtgebundene Kommunikation zwischen in der Flächenverkleidungselement-Anordnung integrierten Elektronikmodulen 18 eines Sensornetzwerkes ermöglicht wird. Die Elektronikmodule 18 können wie im vorangegangenen beschrieben ausgebildet sein und sind in den Figuren 7A bis 7C der Übersichtlichkeit halber nicht gezeigt. Das Flächenverkleidungselement 700 weist eine erste Datenleitung 14 auf (auch erste Datenverbindung oder erste Datenverbindungsleitung genannt), welche über der ersten Oberfläche 1a der elektrisch nichtleitfähigen Basisschicht 1 (anschaulich an der Oberseite des Flächenverkleidungselementes 700) ausgebildet ist und von einem Rand des Flächenverkleidungselementes 700 aus zu dem Durchgangsloch 24 hin führt, sowie zwei zweite Datenleitungen 15 (auch zweite Datenverbindungen oder zweite Datenverbindungsleitungen genannt), welche über der zweiten Oberfläche 1b der Basisschicht 1 (anschaulich an der Unterseite des Flächenverkleidungselementes 700) ausgebildet sind und parallel zu den Masseleitungen 11 zu dem Durchgangsloch 24 hin führen. Das Flächenverkleidungselement 700 weist an seiner Oberseite zwei elektrisch leitfähige Bereiche 8c ohne spezielle Funktion auf.

Ein Vorteil eines Netzwerkes mit drahtgebundener Kommunikation zwischen den einzelnen Netzwerkelementen 18 besteht in der Möglichkeit, die physikalischen Positionen der einzelnen Netzwerkmodule 18 mittels Selbstorganisation bestimmen zu können. Ein derartiges Verfahren zur Selbstorganisation miteinander gekoppelter Netzwerkelemente ist beispielsweise in [3] beschrieben.

Ein entscheidender Punkt für die Selbstorganisation eines solchen Netzwerkes ist die Verbindung der Datenleitungen zwischen allen Modulen und bahnübergreifend auf benachbarte Bahnen. Die Module weisen zu diesem Zweck an jeder Seite eine eigene Schnittstelle auf für den drahtgebundenen Datenaustausch mit den Nachbarmodulen.

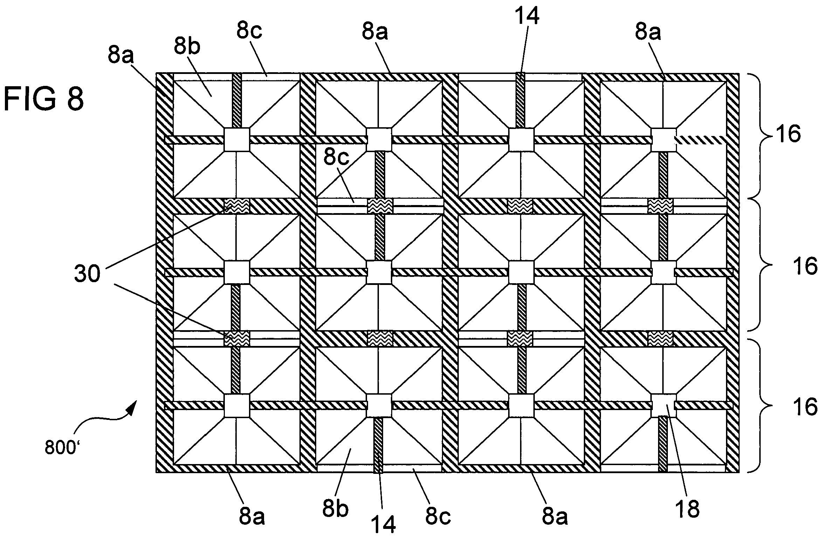

Bei einer in **Fig.8** gezeigten Flächenverkleidungselement-Anordnung 800' gemäß einem Ausführungsbeispiel der Erfindung wird die Verbindung der Datenleitungen dadurch erreicht, dass auf der Oberseite der Flächenverkleidungselement-Anordnung 800' die Versorgungsspannung 8a in Mäanderform um die einzelnen Raster der Flächenverkleidungselement-Anordnung 800' gelegt wird und zusätzlich durch jedes Modul 18 durchgeschaltet wird. Durch den Mäander zum Rand der Bahnen 16 ergibt sich eine Öffnung zur Nachbarbahn 16, welche Öffnung für die kreuzungsfreie Durchführung der ersten Datenleitung 14 genutzt wird. Die Trennbereiche 50 können so breit ausgelegt werden, dass beim späteren Verbinden der einzelnen Bahnen 16 eine leichte Justierung des leitfähigen Klebestreifens 30 erfolgen kann.

Auf der Unterseite der Flächenverkleidungselement-Anordnung 800' laufen die zweiten Datenleitungen 15 zwischen den Modulen 18 parallel zum Rand der Bahn 16. Die Module 18 besitzen in diesem Fall an ihrer Unterseite entsprechende Kontaktpads zum Anschluss der zweiten Datenleitungen 15. Der elektrisch leitfähige Streifen 26 verbindet die außen liegenden Masseanschlüsse 11 miteinander und schließt gleichzeitig die Massefläche 5 des Moduls 18 auf dessen Unterseite an. Nach dem Kontaktieren des Moduls 18 kann der Bereich mit einem nichtleitfähigen Material 29 zum Befestigen des Moduls 18 außerhalb der Masseleitung 26 mechanisch stabilisiert werden (siehe Fig.7C).

Zur Veranschaulichung der Verbindungsstruktur auf der Oberseite der Flächenverkleidung sind in Fig.8 drei Bahnen 16 mit einer Bahnbreite von einem Rasterelement über die elektrisch leitfähigen Klebestreifen 30 miteinander verbunden. Bei der Verlegung des Bodens muss darauf geachtet werden, dass ein Rapport von einem Rasterelement notwendig ist.

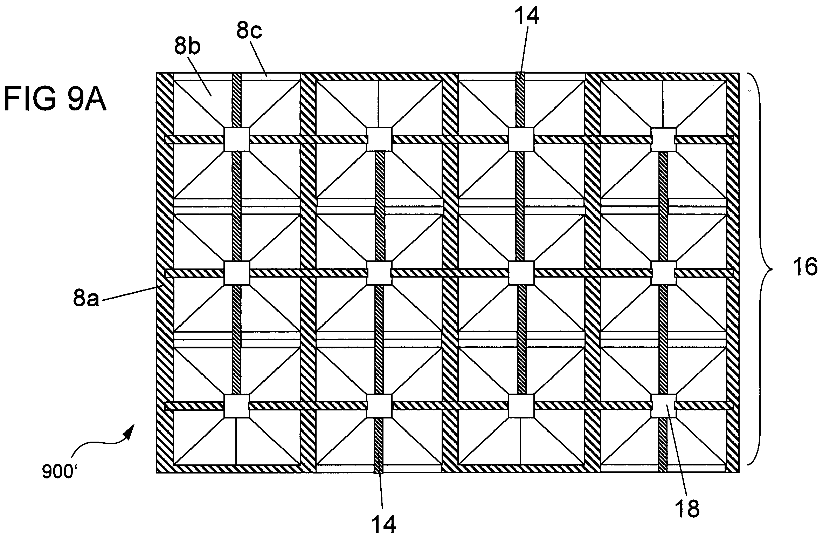

**Fig.9A** zeigt die Oberseite einer Bahn 16 mit einer Breite von drei Rasterelementen, welche Teil einer Flächenverkleidungselement-Anordnung 900' gemäß einem anderen Ausführungsbeispiel der Erfindung ist. Fig.9A zeigt die mäanderförmige Führung der Versorgungsspannung 8a sowie das Durchschalten der Versorgungsspannung durch die einzelnen Module 18. Ferner ist die Verbindung von Modulen 18 benachbarter Flächenverkleidungselemente bzw. Raster der Anordnung 900' mittels erster Datenleitungen 14 zu erkennen.

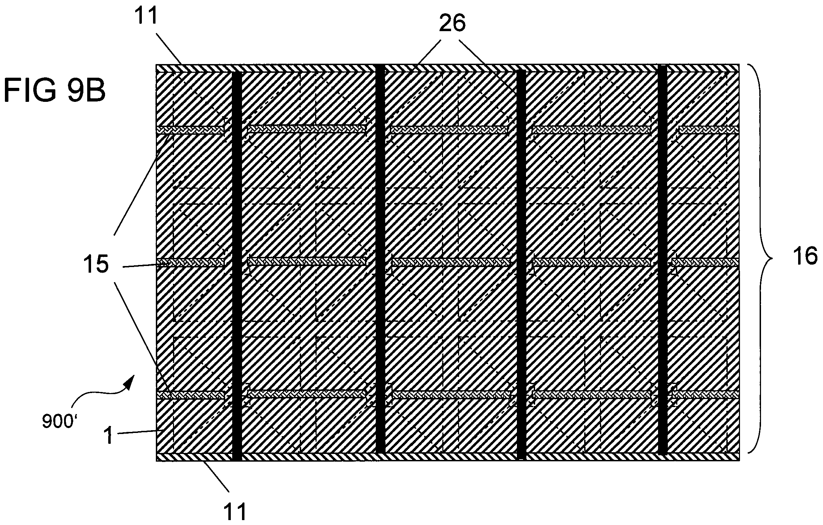

Analog dazu zeigt **Fig.9B** die Unterseite einer Bahn 16 der Flächenverkleidungselement-Anordnung 900' mit einer Breite von drei Rasterelementen. Hier laufen die Masseanschlüsse 26 (elektrisch leitfähige Klebestreifen 26) der Module 18 von der Masseleitung 11 am Rand der Bahn 16 im rechten Winkel zu den Modulen 18. Die zweiten Datenleitungen 15 laufen parallel zu den Bahnen 16. Die Kontaktierung der Datenleitungen 14, 15 der Flächenverkleidungselement-Anordnung 900' kann an der Unterseite an den Schnittkanten der Bahnen 16 oder an der Oberseite an den Bahnkanten erfolgen. Zur Kontaktierung kann, wie bei der Verbindung der Bahnen 16 untereinander, beispielsweise ein elektrischer leitfähiger Streifen verwendet werden.

In diesem Dokument sind folgende Veröffentlichungen zitiert:
[1] http://www.vorwerk-teppich.de/sc/vorwerk/img/ thinking_carpet.doc
[2] DE 10 2004 001 661 A1
[3] DE 101 58 784 A1
[4] DE 103 07 505 A1

### Bezugszeichenliste

- S1,S2,S3,S4, S5,S6,S7,S8: Sensorflächen
- 1: elektrisch nichtleitfähige Schicht
- 1a: erste Oberfläche
- 1b: zweite Oberfläche
- 2: Zwischenträger
- 2a: erste Hauptoberfläche
- 2b: zweite Hauptoberfläche
- 3: integrierter Schaltkreis
- 4: erster erster elektrischer Kontakt
- 5: zweiter elektrischer Kontakt
- 6: zweiter erster elektrischer Kontakt
- 8: erste elektrisch leitfähige Schicht
- 8a: elektrische Leiterbahn
- 8b: Sensorfläche
- 8c: Blinder Fleck (keine Funktion)
- 11: elektrisch leitfähige Bahn
- 13: Isolierschicht
- 14: leitfähige Balm für Datenleitungsverbindung zu Nachbarbahnen
- 15: leitfähige Bahn für Datenleitung in Bahnrichtung
- 16: Bahn mit mehreren Rastern
- 18: Elektronikmodul
- 21: erste Klebeschicht
- 22: zweite Klebeschicht
- 23: Trennkanal
- 24: Durchgangsloch
- 25: elektrisch leitfähiger Kleber
- 26: elektrisch leitfähiger Klebestreifen
- 27: dritte Klebeschicht
- 28: Füllschicht
- 29: elektrisch nichtleitfähige Schicht
- 30: elektrisch leitfähiges Klebeband
- 31: isolierender Streifen
- 40a: erster Randbereich
- 40b: zweiter Randbereich
- 41: leitfähiger flexibler Kontaktstreifen
- 50: Unterbrechung der Versorgungsleitung

- 100: Textilschicht-Anordnung
- 101: erste nichtleitfähige Textilschicht
- 102: Zwischenträger
- 103: Mikroelektronik-Chip
- 104: erster elektrischer Kontakt
- 105: zweiter elektrischer Kontakt
- 106: dritter elektrischer Kontakt
- 107: Zuleitung
- 108: leitfähiges Textilband
- 109: elektrisch leitfähige Bahn
- 110: Sensorfläche
- 111: elektrisch leitfähige Schicht
- 112: Durchkontaktierung zum Masseanschluss
- 113: zweite nichtleitfähige Textilschicht
- 180: mechanische Verbindung als Zugentlastung (nichtleitfähige Naht)

- 200: Flächenverkleidungselement
- 200a: erstes Flächenverkleidungselement
- 200b: zweites Flächenverkleidungselement
- 600: Flächenverkleidungselement
- 700: Flächenverkleidungselement
- 800': Flächenverkleidungselement-Anordnung
- 900': Flächenverkleidungselement-Anordnung

## Patentansprüche

1. Textiles Flächenverkleidungselement (200),
• mit einer textilen, elektrisch nichtleitfähigen Schicht (1);
• mit einer ersten elektrisch leitfähigen Schicht (8), welche zumindest über einem Teilbereich einer ersten Oberfläche (1a) der textilen, elektrisch nichtleitfähigen Schicht (1) ausgebildet ist;
• mit einer zweiten elektrisch leitfähigen Schicht (26), welche zumindest über einem Teilbereich einer zweiten Oberfläche (1b) der textilen, elektrisch nichtleitfähigen Schicht (1) ausgebildet ist, wobei die zweite Oberfläche (1b) der ersten Oberfläche (1a) gegenüberliegend ausgebildet ist;
• mit mindestens einem Durchgangsloch (24), welches in der textilen, elektrisch nichtleitfähigen Schicht (1) und in der ersten elektrisch leitfähigen Schicht (8) ausgebildet ist;
• mit mindestens einem integrierten Schaltkreis (3), welcher in dem mindestens einen Durchgangsloch (24) angeordnet ist;
• mit mindestens einem ersten mechanisch flexiblen Kontaktierungselement (2, 4, 6), welches einen außerhalb des Durchgangslochs (24) angeordneten Teil aufweist, der den mindestens einen integrierten Schaltkreis (3) mit der ersten elektrisch leitfähigen Schicht (8) elektrisch kontaktiert;
• mit mindestens einem zweiten Kontaktierungselement (5), welches den mindestens einen integrierten Schaltkreis (3) mit der zweiten elektrisch leitfähigen Schicht (26) elektrisch kontaktiert.

2. Textiles Flächenverkleidungselement (200) gemäß Anspruch 1,
mit mindestens einem Zwischenträger (2), welcher zumindest teilweise in dem Durchgangsloch (24) angeordnet ist, wobei der mindestens eine integrierte Schaltkreis (3) auf einer ersten Hauptoberfläche (2a) des mindestens einen Zwischenträgers (2) ausgebildet ist.

3. Textiles Flächenverkleidungselement (200) gemäß Anspruch 2,
wobei eine zweite Hauptoberfläche (2b) des mindestens einen Zwischenträgers (2), welche der ersten Hauptoberfläche (2a) gegenüberliegend ausgebildet ist, eine gemeinsame Grenzfläche mit der ersten elektrisch leitfähigen Schicht (8) und/oder mit der zweiten elektrisch leitfähigen Schicht (26) aufweist.

4. Textiles Flächenverkleidungselement (200) gemäß Anspruch 3,
wobei das mindestens eine erste Kontaktierungselement (2, 4, 6) mindestens einen ersten elektrischen Kontakt (4, 6) aufweist, welcher in einem Randbereich des Zwischenträgers (2) ausgebildet ist.

5. Textiles Flächenverkleidungselement (200) gemäß einem der Ansprüche 1 bis 4, wobei das mindestens eine zweite Kontaktierungselement (5) als eine Masseschicht des integrierten Schaltkreises (3) ausgebildet ist, welche Masseschicht eine gemeinsame Grenzfläche mit der zweiten elektrisch leitfähigen Schicht (26) aufweist.

6. Textiles Flächenverkleidungselement (200) gemäß einem der Ansprüche 1 bis 5, wobei die textile, elektrisch nichtleitfähige Schicht (1) mindestens eines der folgenden Materialien aufweist:
• ein Vlies-Material;
• ein Schaumstoff-Material;
• ein Kunststoff-Material.

7. Textiles Flächenverkleidungselement (200) gemäß einem der Ansprüche 1 bis 6, wobei eine Klebeschicht (21) zwischen der textilen, elektrisch nichtleitfähigen Schicht (1) und der ersten elektrisch leitfähigen Schicht (8) ausgebildet ist.

8. Textiles Flächenverkleidungselement (200) gemäß einem der Ansprüche 1 bis 7, wobei die erste elektrisch leitfähige Schicht (8) so strukturiert ist, dass sie eine Mehrzahl von elektrisch leitfähigen Bereichen (8a, 8b) aufweist, welche als elektrische Versorgungsleitung (8a) und/oder als Sensorfläche (8b) ausgebildet sind, wobei die elektrisch leitfähigen Bereiche (8a, 8b) mittels mindestens eines Trennbereiches (23) voneinander elektrisch isoliert sind.

9. Textiles Flächenverkleidungselement (200) gemäß einem der Ansprüche 3 bis 8, mit einer textilen, elektrisch nichtleitfähigen Klebeschicht (29) zur mechanischen Befestigung des Zwischenträgers (2), welche textile, elektrisch nichtleitfähige Klebeschicht (29) zumindest teilweise auf der zweiten Hauptoberfläche (2b) des Zwischenträgers und/oder zumindest teilweise auf der zweiten elektrisch leitfähigen Schicht (26) und/oder zumindest teilweise auf der textilen, elektrisch nichtleitfähigen Schicht (1) ausgebildet ist.

10. Textiles Flächenverkleidungselement (200) gemäß einem der Ansprüche 1 bis 9, wobei eine Füllschicht (28) auf dem integrierten Schaltkreis (3) und/oder dem Zwischenträger (2) in dem Durchgangsloch (24) aufgebracht ist, welche Füllschicht (28) das Durchgangsloch (24) ausfüllt.

11. Textiles Flächenverkleidungselement (200) gemäß einem der Ansprüche 1 bis 10, wobei der mindestens eine integrierte Schaltkreis (3) als Elektronikmodul eingerichtet ist.

12. Textile Flächenverkleidungselement-Anordnung (800'),
mit einer Mehrzahl von nebeneinander angeordneten textilen Flächenverkleidungselementen gemäß einem der Ansprüche 1 bis 11, wobei die textilen Flächenverkleidungselemente mittels einer elektrischen Versorgungsleitung (8a) und/oder mittels einer Masseleitung miteinander elektrisch gekoppelt sind.

13. Verfahren zum Herstellen eines textilen Flächenverkleidungselementes (200), bei dem
• eine erste elektrisch leitfähige Schicht (8) über zumindest einem Teilbereich einer ersten Oberfläche (1a) einer textilen, elektrisch nichtleitfähigen Schicht (1) gebildet wird;
• eine zweite elektrisch leitfähige Schicht (26) über zumindest einem Teilbereich einer zweiten Oberfläche (1b) der textilen, elektrisch nichtleitfähigen Schicht (1) gebildet wird, wobei die zweite Oberfläche (1b) der ersten Oberfläche (1a) gegenüberliegend ausgebildet ist;
• mindestens ein Durchgangsloch (24) in der textilen, elektrisch nichtleitfähigen Schicht (1) und in der ersten elektrisch leitfähigen Schicht (8) gebildet wird;
• mindestens ein integrierter Schaltkreis (3) in dem mindestens einen Durchgangsloch (24) angeordnet wird;
• mindestens ein erstes mechanisch flexibles Kontaktierungselement (2, 4, 6) zumindest teilweise in dem mindestens einen Durchgangsloch (24) angeordnet wird, welches mindestens eine erste Kontaktierungselement (2, 4, 6) einen außerhalb des Durchgangslochs (24) angeordneten Teil aufweist, der den mindestens einen integrierten Schaltkreis (3) mit der ersten elektrisch leitfähigen Schicht (8) elektrisch kontaktiert;
• mindestens ein zweites Kontaktierungselement (5) in dem mindestens einen Durchgangsloch (24) angeordnet wird, welches mindestens eine zweite Kontaktierungselement (5) den mindestens einen integrierten Schaltkreis (3) mit der zweiten elektrisch leitfähigen Schicht (26) elektrisch kontaktiert.

14. Verfahren gemäß Anspruch 13,
wobei das Bilden der ersten elektrisch leitfähigen Schicht (8) erfolgt, indem eine elektrisch leitfähige Schicht ganzflächig auf die erste Oberfläche (1a) der textilen, elektrisch nichtleitfähigen Schicht (1) aufgebracht wird und nachfolgend strukturiert wird.

15. Verfahren gemäß Anspruch 13 oder 14,
• wobei der mindestens eine integrierte Schaltkreis (3) auf einer ersten Hauptoberfläche (2a) mindestens eines mechanisch flexiblen Zwischenträgers (2) ausgebildet ist;
• wobei das erste Kontaktierungselement (2, 4, 6) mindestens einen ersten elektrischen Kontakt (4, 6) aufweist, welcher auf einer zweiten Hauptoberfläche (2b) des mindestens einen Zwischenträgers (2) in einem Randbereich des mindestens einen Zwischenträgers (2) ausgebildet ist, wobei die zweite Hauptoberfläche (2b) der ersten Hauptoberfläche (2a) gegenüberliegend ausgebildet ist;
• wobei das zweite Kontaktierungselement (5) mindestens einen zweiten elektrischen Kontakt (5) aufweist, welcher auf der zweiten Hauptoberfläche (2b) des mindestens einen Zwischenträgers (2) ausgebildet ist; und
• wobei der mindestens eine Zwischenträger (2) zumindest teilweise in dem mindestens einen Durchgangsloch (24) angeordnet wird, derart, dass der Randbereich außerhalb des Durchgangsloches (24) angeordnet ist, dass der mindestens eine erste elektrische Kontakt (4, 6) eine gemeinsame Grenzfläche mit der ersten elektrisch leitfähigen Schicht (8) aufweist, und dass der mindestens eine zweite elektrische Kontakt (5) eine gemeinsame Grenzfläche mit der zweiten elektrisch leitfähigen Schicht (26) aufweist.

## Claims

1. Textile surface covering element (200),
• including a textile, electrically non-conductive layer (1),
• including a first electrically conductive layer (8) which is formed at least above a partial region of a first surface (1a) of the textile, electrically non-conductive layer (1),
• including a second electrically conductive layer (26) which is formed at least above a partial region of a second surface (1b) of the textile, electrically non-conductive layer (1), the second surface (1b) being formed opposite the first surface (1a),
• including at least one through-hole (24) which is formed in the textile, electrically non-conductive layer (1) and in the first electrically conductive layer (8),
• including at least one integrated circuit (3) which is disposed in the at least one through-hole (24),
• including at least one first mechanically flexible contacting element (2, 4, 6) comprising a part arranged outside the through-hole (24), which electrically contacts the at least one integrated circuit (3) with the first electrically conductive layer (8),
• including at least one second contacting element (5) which electrically contacts the at least one integrated circuit (3) with the second electrically conductive layer (26).

2. Textile surface covering element (200) according to claim 1,
including at least one subcarrier (2) which is arranged at least in part in the through-hole (24), wherein the at least one integrated circuit (3) is formed on a first main surface (2a) of the at least one subcarrier (2).

3. Textile surface covering element (200) according to claim 2,
wherein the second main surface (2b) of the at least one subcarrier (2), formed opposite the first main surface (2a), comprises a common interface with the first electrically conductive layer (8) and/or with the second electrically conductive layer (26).

4. Textile surface covering element (200) according to claim 3,
wherein the at least one first contacting element (2, 4, 6) comprises at least one first electrical contact (4, 6) which is formed in an edge region of the subcarrier (2).

5. Textile surface covering element (200) according to any of claims 1 to 4,
wherein the at least one second contacting element (5) is formed as a mass layer of the integrated circuit (3), which mass layer comprises a common interface with the second electrically conductive layer (26).

6. Textile surface covering element (200) according to any of claims 1 to 5, wherein the textile, electrically non-conductive layer (1) comprises at least one of the following materials:
• a nonwoven material,
• a foamed material,
• a synthetic material.

7. Textile surface covering element (200) according to any of claims 1 to 6,
wherein an adhesive layer (21) is formed between the textile, electrically non-conductive layer (1) and the first electrically conductive layer (8).

8. Textile surface covering element (200) according to any of claims 1 to 7,
wherein the first electrically conductive layer (8) is structured in a way to comprise a plurality of electrically conductive regions (8a, 8b) which are formed as power supply line (8a) and/or as sensor surface (8b), wherein the electrically conductive regions (8a, 8b) are electrically insulated from each other by means of at least one separating region (23).

9. Textile surface covering element (200) according to any of claims 3 to 8,
including a textile, electrically non-conductive adhesive layer (29) for mechanically attaching the subcarrier (2), which textile, electrically non-conductive adhesive layer (29) is formed at least in part on the second main surface (2b) of the subcarrier and/or at least in part on the second electrically conductive layer (26) and/or at least in part on the textile, electrically non-conductive layer (1).

10. Textile surface covering element (200) according to any of claims 1 to 9,
wherein a filling layer (28) is applied to the integrated circuit (3) and/or the intermediate carrier (2) in the through-hole (24), which filling layer (28) fills the through-hole (24).

11. Textile surface covering element (200) according to any of claims 1 to 10, wherein the at least one integrated circuit (3) is configured as electronic module.

12. Textile surface covering element assembly (800'),
including a plurality of textile surface covering elements according to any of claims 1 to 11, arranged next to each other, wherein the textile surface covering elements are electrically coupled to each other by means of a power supply line (8a) and/or by means of a mass line.

13. Method of producing a textile surface covering element (200), wherein
• a first electrically conductive layer (8) is formed above at least a partial region of a first surface (1a) of a textile, electrically non-conductive layer (1),
• a second electrically conductive layer (26) is formed above at least a partial region of a second surface (1b) of the textile, electrically non-conductive layer (1), wherein the second surface (1b) is formed opposite the first surface (1a),
• at least one through-hole (24) is formed in the textile, electrically non-conductive layer (1) and in the first electrically conductive layer (8),
• at least one integrated circuit (3) is arranged in at the at least one through-hole (24),
• at least one first mechanically flexible contacting element (2, 4, 6) is arranged at least in part in the at least one through-hole (24), which at least one first contacting element (2, 4, 6) comprises a part disposed outside the through-hole (24), which electrically contacts the at least one integrated circuit (3) with the first electrically conductive layer (8),
• at least one second contacting element (5) is arranged in the at least one through-hole (24), which at least one second contacting element (5) electrically contacts the at least one integrated circuit (3) with the second electrically conductive layer (26).

14. Method according to claim 13,
wherein the forming of the first electrically conductive layer (8) is effected by applying an electrically conductive layer over the entire surface of the first surface (1a) of the textile, electrically non-conductive layer (1), and by subsequently structuring the same.

15. Method according to claim 13 or 14,
• wherein the at least one integrated circuit (3) is formed on a first main surface (2a) of at least one mechanically flexible subcarrier (2),
• wherein the first contacting element (2, 4, 6) comprises at least one first electrical contact (4, 6) which is formed on a second main surface (2b) of the at least one subcarrier (2) in an edge region of the at least one subcarrier (2), wherein the second main surface (2b) is formed opposite the first main surface (2a),
• wherein the second contacting element (5) comprises at least one second electrical contact (5) which is formed on the second main surface (2b) of the at least one subcarrier (2), and
• wherein the at least one subcarrier (2) is arranged at least in part in the at least one through-hole (24) in a way that the edge region is arranged outside the through-hole (24), the at least one first electrical contact (4, 6) comprises a common interface with the first electrically conductive layer (8), and the at least one second electrical contact (5) comprises a common interface with the second electrically conductive layer (26).

## Revendications

1. Élément de revêtement de surface textile (200),
• avec une couche non électro-conductrice textile (1) ;
• avec une première couche électro-conductrice (8) qui est réalisée au moins sur une partie d'une première surface (1a) de la couche non électro-conductrice textile (1) ;
• avec une deuxième couche électro-conductrice (26) qui est réalisée au moins sur une partie d'une deuxième surface (1b) de la couche non électro-conductrice textile (1), la deuxième surface (1b) étant réalisée en face de la première surface (1a);
• avec au moins un trou de passage (24) qui est réalisé dans la couche non électro-conductrice textile (1) et dans la première couche électro-conductrice (8) ;
• avec au moins un circuit intégré (3) qui est disposé dans l'au moins un trou de passage (24) ;
• avec au moins un premier élément de contact mécaniquement flexible (2, 4, 6), qui comprend une partie disposée à l'extérieur du trou de passage (24), qui met en contact électrique l'au moins un circuit intégré (3) avec la première couche électro-conductrice (8) ;
• avec au moins un deuxième élément de contact (5) qui met en contact électrique l'au moins un circuit intégré (3) avec la deuxième couche électro-conductrice (26).

2. Élément de revêtement de surface textile (200) selon la revendication 1,
avec au moins un support intermédiaire (2) qui est disposé au moins partiellement dans le trou de passage (24), l'au moins un circuit intégré (3) étant réalisé sur une première surface principale (2a) de l'au moins un support intermédiaire (2).

3. Élément de revêtement de surface textile (200) selon la revendication 2,
une deuxième surface principale (2b) de l'au moins un support intermédiaire (2), qui est réalisée en face de la première surface principale (2a), comprenant une surface limite commune avec la première couche électro-conductrice (8) et/ou avec la deuxième couche électro-conductrice (26).

4. Élément de revêtement de surface textile (200) selon la revendication 3,
l'au moins un premier élément de contact (2, 4, 6) comprenant au moins un premier contact électrique (4, 6) qui est réalisé dans un bord du support intermédiaire (2).

5. Élément de revêtement de surface textile (200) selon l'une des revendications 1 à 4,
l'au moins un deuxième élément de contact (5) étant conçu comme une couche de masse du circuit intégré (3), cette couche de masse comprenant une surface limite commune avec la deuxième couche électro-conductrice (26).

6. Élément de revêtement de surface textile (200) selon l'une des revendications 1 à 5,
la couche non électro-conductrice textile (1) comprenant au moins un des matériaux suivants :
• un matériau non tissé ;
• une mousse ;
• une matière plastique.

7. Élément de revêtement de surface textile (200) selon l'une des revendications 1 à 6,
une couche adhésive (21) étant réalisée entre la couche non électro-conductrice textile (1) et la première couche électro-conductrice (8).

8. Élément de revêtement de surface textile (200) selon l'une des revendications 1 à 7,
la première couche électro-conductrice (8) étant structurée de façon à comprendre une pluralité de zones électro-conductrices (8a, 8b) qui sont conçues comme une ligne d'alimentation (8a) et/ou comme une surface de capteur (8b), les zones électro-conductrices (8a, 8b) étant isolées électriquement entre elles au moyen d'au moins une zone de séparation (23).

9. Élément de revêtement de surface textile (200) selon l'une des revendications 3 à 8,
avec une couche adhésive non électro-conductrice textile (29) pour la fixation mécanique du support intermédiaire (2), cette couche adhésive non électro-conductrice textile (29) étant réalisée au moins partiellement sur la deuxième surface principale (2b) du support intermédiaire et/ou au moins partiellement sur la deuxième couche électro-conductrice (26) et/ou au moins partiellement sur la couche non électro-conductrice textile (1).

10. Élément de revêtement de surface textile (200) selon l'une des revendications 1 à 9,
une couche de remplissage (28) étant appliquée sur le circuit intégré (3) et/ou le support intermédiaire (2) dans le trou de passage (24), cette couche de remplissage (28) remplissant le trou de passage (24).

11. Élément de revêtement de surface textile (200) selon l'une des revendications 1 à 10,
l'au moins un circuit intégré (3) étant conçu comme un module électronique.

12. Disposition d'élément de revêtement de surface textile (800'),
avec une pluralité d'éléments de revêtement de surface textiles selon l'une des revendications 1 à 11 juxtaposés, les éléments de revêtement de surface textiles étant couplés électriquement entre eux au moyen d'une ligne d'alimentation électrique (8a) et/ou au moyen d'une ligne de masse.

13. Procédé de fabrication d'un élément de revêtement de surface textile (200), dans lequel
• une première couche électro-conductrice (8) est formée sur au moins une partie d'une première surface (1a) d'une couche non électro-conductrice textile (1) ;
• une deuxième couche électro-conductrice (26) est formée sur au moins une partie d'une deuxième surface (1b) d'une couche non électro-conductrice textile (1), la deuxième surface (1b) étant réalisée en face de la première surface (1a) ;
• au moins un trou de passage (24) est réalisé dans la couche non électro-conductrice textile (1) et dans la première couche électro-conductrice (8) ;
• au moins un circuit intégré (3) est disposé dans l'au moins un trou de passage (24);
• au moins un premier élément de contact mécaniquement flexible (2, 4, 6) est disposé au moins partiellement dans l'au moins un trou de passage (24), cet au moins un premier élément de contact (2, 4, 6) comprenant une partie disposée à l'extérieur du trou de passage (24), qui met en contact l'au moins un circuit intégré (3) avec la première couche électro-conductrice (8) ;
• au moins un deuxième élément de contact (5) est disposé dans l'au moins un trou de passage (24), cet au moins un deuxième élément de contact (5) mettant en contact électrique l'au moins un circuit intégré (3) avec la deuxième couche électro-conductrice (26).

14. Procédé selon la revendication 13,
la formation de la première couche électro-conductrice (8) ayant lieu en appliquant une couche électro-conductrice sur toute la première surface (1a) de la couche non électro-conductrice textile (1) puis en la structurant.

15. Procédé selon la revendication 13 ou 14,
• l'au moins un circuit intégré (3) étant réalisé sur une première surface principale (2a) d'au moins un support intermédiaire mécaniquement flexible (2) ;
• le premier élément de contact (2, 4, 6) comprenant au moins un premier contact électrique (4, 6) qui est réalisé sur une deuxième surface principale (2b) de l'au moins un support intermédiaire (2) dans un bord de l'au moins un support intermédiaire (2), la deuxième surface principale (2b) étant réalisée en face de la première surface principale (2a) ;
• le deuxième élément de contact (5) comprenant au moins un deuxième contact électrique (5) qui est réalisé sur la deuxième surface principale (2b) de l'au moins un support intermédiaire (2) ; et
• l'au moins un support intermédiaire (2) étant disposé au moins partiellement dans l'au moins un trou de passage (24) de façon à ce que le bord soit disposé à l'extérieur du trou de passage, à ce que l'au moins un premier contact électrique (4, 6) comprenne une surface limite commune avec la première couche électro-conductrice (8) et à ce que l'au moins un deuxième contact électrique (5) comprenne une surface limite commune avec la deuxième couche électro-conductrice (26).
